(19) Europäisches Patentamt
European Patent Office
Office européen des brevets

(11) **EP 4 218 141 B1**

(12) **EUROPEAN PATENT SPECIFICATION**

(45) Date of publication and mention
of the grant of the patent:
**19.06.2024 Bulletin 2024/25**

(21) Application number: **20797704.2**

(22) Date of filing: **23.10.2020**

(51) International Patent Classification (IPC):
*H03M 13/13* (2006.01)     *H03M 13/25* (2006.01)
*H03M 13/27* (2006.01)     *H03M 13/35* (2006.01)
*H04B 7/0413* (2017.01)

(52) Cooperative Patent Classification (CPC):
**H03M 13/13; H03M 13/251; H03M 13/2707;
H03M 13/356;** H04B 7/0413

(86) International application number:
**PCT/EP2020/079895**

(87) International publication number:
**WO 2022/083876 (28.04.2022 Gazette 2022/17)**

(54) **CODEWORD BIT INTERLEAVING SCHEME FOR MULTILAYER TRANSMISSIONS IN WIRELESS COMMUNICATION SYSTEM**

CODEWORT-BITVERSCHACHTELUNGSSCHEMA FÜR MEHRSCHICHTIGE ÜBERTRAGUNGEN IN EINEM DRAHTLOSKOMMUNIKATIONSSYSTEM

PRINCIPE D´ENTRELACEMENT DE BITS DE MOTS DE CODE POUR TRANSMISSIONS MULTICOUCHES DANS UN SYSTÈME DE COMMUNICATION SANS FIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.08.2023 Bulletin 2023/31**

(73) Proprietor: **Huawei Technologies Co., Ltd.
Shenzhen, Guangdong 518129 (CN)**

(72) Inventors:
• **POPOVIC, Branislav, M.
16440 Kista (SE)**
• **PEROTTI, Alberto, Giuseppe
16440 Kista (SE)**

(74) Representative: **MERH-IP Matias Erny Reichl Hoffmann
Patentanwälte PartG mbB
Paul-Heyse-Strasse 29
80336 München (DE)**

(56) References cited:
**US-A1- 2009 063 929     US-A1- 2018 212 628
US-A1- 2020 119 845**

## Description

### TECHNICAL FIELD

The disclosure relates generally to the field of wireless communications, and particularly to a codeword bit interleaving scheme for multilayer transmissions in a wireless communication system.

### BACKGROUND

The fifth generation (5G) of mobile wireless communication networks, such as the 3rd Generation Partnership Project (3GPP) New Radio (NR), use a Multiple-Input Multiple-Output (MIMO) approach in order to achieve very high data rates for transmission between a base station (BS) or gNodeB (gNB) and a user equipment (UE). The MIMO approach exploits multipath propagation over a radio channel by using multiple transmitter and receiver antennas in order to create multiple spatial layers (also referred to as MIMO layers) whereon information can be transmitted concurrently. The propagation phenomena that occur on the radio channel often cause large imbalances among Signal-to-Noise Ratios (SNRs) of the MIMO layers. Large SNR imbalances may cause performance degradations if they are not properly addressed.

In the NR, any data stream exchanged between the gNB and the UE consists of a sequence of data blocks. Each data block is independently encoded into a codeword by using an error correction code. The NR relies on Low-Density Parity-Check (LDPC) codes for error correction. Codeword bits are then interleaved and modulated to be transmitted to the gNB or the UE over the MIMO layers.

However, the NR uses the same modulation and code rate on all MIMO layers even though the MIMO layers may have large SNR imbalances. To guarantee given transmission reliability, modulation/code rate selection is done based on a transmission quality peculiar to the worst (i.e. low-SNR) MIMO layers. This makes it impossible to fully exploit the transmission quality of the high-SNR MIMO layers, thereby resulting in limited bit rates.

Document US 2009/063929 A1 generally discloses an apparatus for transmitting data in a communication system using an LDPC matrix. The apparatus includes an interleaver for interleaving a descending bit-ordered codeword having a predetermined size and in accordance with a predetermined modulation scheme; and a bit mapper for mapping codeword bits constituting the interleaved codeword in accordance with a predetermined mapping scheme that takes into account degrees of the codeword bits and reliability characteristics of modulation symbol-constituting bits based on the predetermined modulation scheme.

US 2018/212628 A1 and US 2020/119845 A1 are further prior art.

### SUMMARY

This summary is provided to introduce a selection of concepts in a simplified form that are further described below in the detailed description. This summary is not intended to identify key features of the disclosure, nor is it intended to be used to limit the scope of the disclosure.

It is an objective of the disclosure to provide a technical solution that enables codeword bit interleaving for multilayer transmissions in a wireless communication system.

The objective above is achieved by the features of the independent claims in the appended claims. Further embodiments and examples are apparent from the dependent claims, the detailed description and the accompanying drawings.

According to a first aspect, an apparatus for a wireless communication system is provided. The apparatus comprises a processor, a memory coupled to the processor, and a transceiver. The memory stores processor-executable instructions. When executed, the processor-executable instructions cause the processor to operate as follows. At first, the processor receives a codeword to be sent over data transmission layers. Each of the data transmission layers has a transmission quality, and the codeword is obtained using a linear code. The codeword has a codeword length $E$ and comprises codeword bits. The codeword bits comprise at least one information bit and at least one parity bit. Then, the processor proceeds with interleaving the codeword bits by using a matrix with $n$ rows and $k$ columns, where $n$ and $k$ are selected based on a predefined modulation scheme and the codeword length $E$. Each of the columns corresponds to one of the data transmission layers. The interleaving operation comprises:

- arranging, into at least one first column group, the columns corresponding to the data transmission layers whose transmission qualities are equal to or above a threshold;
- arranging, into at least one second column group, the columns corresponding to the data transmission layers whose transmission qualities are below the threshold;
- writing the codeword bits row-wise into the at least one first column group and the at least one second column group, starting with writing the at least one information bit row-wise into the at least one first column group;
- merging the at least one first column group and the at least one second column group to restore the matrix; and
- reading the codeword bits column-wise from the matrix.

When the interleaving operation is finished, the processor uses the predefined modulation scheme to obtain a modulation symbol for the codeword bits read from each column of the matrix. After that, the processor maps the modulation symbols to the data transmission layers. Next, the transceiver sends the mapped modulation symbols to a target apparatus in the wireless communication system.

By performing the interleaving operation in this way, the apparatus according to the first aspect may map the information bits of the codeword to the data transmission layers with high transmission qualities (e.g., high SNRs) even when the codeword is transmitted on multiple data transmission layers with significantly different transmission qualities. In turn, such mapping may improve decoding performance in the target apparatus, thereby achieving smaller error rates and larger spectral efficiency.

In the first aspect, the predefined modulation scheme has a modulation order $Q_m$, and $n$ is equal to the modulation order $Q_m$. At the same time, $k$ is obtained by applying a floor or ceiling function to a ratio of the codeword length E to the modulation order $Q_m$. By so doing, it is possible to create a more efficient interleaving matrix, thereby increasing the efficiency of the whole interleaving operation.

In one embodiment of the first aspect, the processor is further configured, before the interleaving operation, to determine the modulation order $Q_m$ of the predefined modulation scheme based on the transmission qualities of the data transmission layers. By so doing, it is possible to select the modulation order $Q_m$ more suitable for the given data transmission layers, thereby increasing the efficiency of the whole interleaving operation.

In the first aspect, the predefined modulation scheme defines a mapping of a $Q_m$-tuple of the codeword bits for each column of the matrix to the modulation symbol, and the processor is further configured to:

- determine bit capacities of the codeword bits in each $Q_m$- tuple based on the transmission qualities of the data transmission layers; and

- based on the determined bit capacities, determine: (i) a number $G$ of the at least one first column group (802) and the at least one second column group (804) into which the columns of the matrix (800) are to be arranged, and (ii) a correspondence of each of the data transmission layers to the at least one first column group (802) or the at least one second column group (804).

By so doing, it is possible to increase the efficiency of grouping the columns of the matrix used in the interleaving operation, thereby increasing the efficiency of the whole interleaving operation.

In the first aspect, the processor is further configured, prior to the transceiver sending the mapped modulation symbols to the target apparatus, to generate a control message and cause the transceiver to send the control message to the target apparatus. The control message may comprise at least one of the following: the modulation order $Q_m$; the codeword length E; the number G of the at least one first column group and the at least one second column group used when interleaving the codeword bits; and the correspondence of each of the data transmission layers to the at least one first column group or the at least one second column group. By so doing, it is possible to provide the target apparatus with information about the codeword bit interleaving scheme used by the apparatus according to the first aspect, thereby allowing the target apparatus to perform deinterleaving and, consequently, decoding operations more efficiently and faster.

In one embodiment of the first aspect, the codeword is obtained using the linear code selected from one of a turbo code, a systematic code, a systematic polar code, and a LDPC code. This may make the apparatus according to the first aspect more flexible in use because, for example, LDPC codes may be used in the 5G NR.

In one embodiment of the first aspect, the predefined modulation scheme comprises one of a quadrature amplitude modulation (QAM) scheme, a Phase Shift Keying (PSK) modulation scheme, and a Quadrature PSK (QPSK) modulation scheme. This may make the apparatus according to the first aspect more flexible in use because it may choose among the modulation schemes depending on particular application.

In one embodiment of the first aspect, the processor is further configured to determine the transmission qualities of the data transmission layers in advance based on uplink reference signals in case of Time-Division Duplexing (TDD) communications or downlink reference signals in case of Frequency-Division Duplexing (FDD) communications. This may make the apparatus according to the first aspect more flexible in use because it may be adapted for different duplex communication links.

In one embodiment of the first aspect, the data transmission layers comprise MIMO spatial layers. This may allow the apparatus according to the first aspect to be used in MIMO wireless communication systems, thereby increasing its flexibility in use.

According to a second aspect, a method for wireless communications is provided. The method starts with the step of receiving a codeword to be sent over data transmission layers. Each of the data transmission layers has a transmission quality, and the codeword is obtained using a linear code. The codeword has a codeword length E and comprises codeword bits. The codeword bits comprise at least one information bit and at least one parity bit. Then, the method proceeds to the step of interleaving the codeword bits by using a matrix with $n$ rows and $k$ columns, where $n$ and $k$ are selected based on a predefined modulation scheme and the codeword length $E$. Each of the columns corresponds to one of the data transmission layers. The interleaving step comprises the following sub-steps:

- arranging, into at least one first column group, the columns corresponding to the data transmission layers whose transmission qualities are equal to or above a threshold;

- arranging, into at least one second column group, the columns corresponding to the data transmission layers whose transmission qualities are below the threshold;

- writing the codeword bits row-wise into the at least one first column group and the at least one second column group, starting with writing the at least one information bit row-wise into the at least one first column group;

- merging the at least one first column group and the at least one second column group to restore the matrix; and

- reading the codeword bits column-wise from the matrix.

When the interleaving step is finished, the method proceeds to the step of obtaining, by using the predefined modulation scheme, a modulation symbol for the codeword bits read from each column of the matrix. After that, the next step of the method is initiated, in which the modulation symbols are mapped to the data transmission layers. Next, the method goes on to the step of sending the mapped modulation symbols to a target wireless communication apparatus.

By performing the interleaving step in this way, it is possible to map the information bits of the codeword to the data transmission layers with high transmission qualities (e.g., high SNRs) even when the codeword is transmitted on multiple data transmission layers with significantly different transmission qualities. In turn, such mapping may improve decoding performance in the target wireless communication apparatus, thereby achieving smaller error rates and larger spectral efficiency.

In the second aspect, the predefined modulation scheme has a modulation order $Q_m$, and $n$ is equal to the modulation order $Q_m$. At the same time, $k$ is obtained by applying a floor or ceiling function to a ratio of the codeword length to the modulation order $Q_m$. By so doing, it is possible to create a more efficient interleaving matrix, thereby increasing the efficiency of the whole interleaving step.

In one embodiment of the second aspect, the method further comprises, before the interleaving step, the step of determining the modulation order $Q_m$ of the predefined modulation scheme based on the transmission qualities of the data transmission layers. By so doing, it is possible to select the modulation order $Q_m$ more suitable for the given data transmission layers, thereby increasing the efficiency of the whole interleaving step.

In the second aspect, the predefined modulation scheme defines a mapping of a $Q_m$-tuple of the codeword bits for each column of the matrix to the modulation symbol. In this embodiment, the method further comprises the steps of:

- determining bit capacities of the codeword bits in each $Q_m$-tuple based on the transmission qualities of the data transmission layers; and
- based on the determined bit capacities, determining: (i) a number G of the at least one first column group (802) and the at least one second column group (804) into which the columns of the matrix (800) are to be arranged, and (ii) a correspondence of each of the data transmission layers to the at least one first column group (802) or the at least one second column group (804).

By so doing, it is possible to increase the efficiency of grouping the columns of the matrix used in the interleaving step, thereby increasing the efficiency of the whole interleaving step.

In the second aspect, the method further comprises, before the sending step, the step of generating and sending a control message to the target wireless communication apparatus. The control message may comprise at least one of the following: the modulation order $Q_m$; the codeword length $E$; the number $G$ of the at least one first column group and the at least one second column group used when interleaving the codeword bits; and the correspondence of each of the data transmission layers to the at least one first column group or the at least one second column group. By so doing, it is possible to provide the target wireless communication apparatus with information about the codeword bit interleaving scheme used in the method according to the second aspect on the transmitting side, thereby allowing the target wireless communication apparatus to deinterleave and, consequently, decode the codeword bits more efficiently and faster.

**EP 4 218 141 B1**

In one embodiment of the second aspect, the codeword is obtained using the linear code selected from one of a turbo code, a systematic code, a systematic polar code, and a LDPC code. This may make the method according to the second aspect more flexible in use because, for example, LDPC codes may be used in the 5G NR.

In one embodiment of the second aspect, the predefined modulation scheme comprises one of a QAM scheme, a PSK modulation scheme, and a QPSK modulation scheme. This may make the method according to the second aspect more flexible in use because it provides the possibility of choosing among the modulation schemes depending on particular application.

In one embodiment of the second aspect, the method further comprises the step of determining the transmission qualities of the data transmission layers in advance based on uplink reference signals in case of Time-Division Duplexing (TDD) communications or downlink reference signals in case of Frequency-Division Duplexing (FDD) communications. This may make the method according to the second aspect more flexible in use because it may be adapted for different duplex communication links.

In one embodiment of the second aspect, the data transmission layers comprise MIMO spatial layers. This may allow the method according to the second aspect to be used in MIMO wireless communication systems, thereby increasing its flexibility in use.

According to a third aspect, a computer program product is provided. The computer program product comprises a computer-readable storage medium storing a computer code. When executed by at least one processor, the computer code causes the at least one processor to perform the method according to the second aspect. By using such a computer program product, it is possible to simplify the implementation of the method according to the second aspect in any computing device, such, for example, as the apparatus according to the first aspect.

Other features and advantages of the disclosure will be apparent upon reading the following detailed description and reviewing the accompanying drawings.

**BRIEF DESCRIPTION OF THE DRAWINGS**

The disclosure is explained below with reference to the accompanying drawings, in which:

FIG. 1 shows a block diagram of a conventional transmitter used to perform NR LDPC-coded transmission;

FIG. 2 shows an exemplary structure of a first codeword segment for initial transmission performed by the conventional transmitter shown in FIG. 1;

FIG. 3 explains interleaving, modulation and layer-mapping operations performed in the conventional transmitter shown in FIG. 1;

FIG. 4 shows dependences of bit capacities $\beta_l^{(Q_m)}$ on $\mathrm{SNR} = 1/\sigma_G^2$ (assuming unit average modulation symbol energy) for different modulation schemes used in the conventional transmitter shown in FIG. 1;

FIG. 5 shows a block diagram of a wireless communication apparatus in accordance with one exemplary embodiment;

FIG. 6 shows a block diagram of a processor used in the apparatus shown in FIG. 5 in accordance with one exemplary embodiment;

FIG. 7 shows a flowchart of a wireless communication method in accordance with one exemplary embodiment;

FIG. 8 explains the interleaving step, modulation step and mapping step of the method shown in FIG. 7 in case of using two column groups;

FIG. 9 shows dependencies $\beta_l^{(4)}(SNR)$, $l$ = 1, ...,4, for a numerical example with 16QAM ($Q_m$ = 4);

FIG. 10 shows matrices used by a conventional interleaver of the conventional transmitter shown in FIG. 1 and an interleaver of the processor shown in FIG. 6, respectively, and corresponding bit capacities for a first transmission in the numerical example;

FIG. 11 shows matrices used by the conventional interleaver of the conventional transmitter shown in FIG. 1 and the interleaver of the processor shown in FIG. 6, respectively, and corresponding bit capacities for a second transmission in the numerical example;

FIG. 12 shows dependencies of a Block Error Rate (BLER) on SNR for the two transmissions in the numerical example;

FIGs. 13A and 13B show the BLER performance of QPSK-modulated and 16QAM-modulated LDPC-coded transmission on $v = 2$ MIMO layers and $G = 2$ column groups;

FIGs. 14A and 14B show a dependence of a metric $\Delta_{CC}$ on SNR for the same code rates and modulations as used for FIGs. 13A and 13B; and

FIGs. 15A and 15B show the BLER performance of the QPSK-modulated and 16QAM-modulated LDPC-coded transmission for various layer SNR differences.

## DETAILED DESCRIPTION

Various embodiments of the disclosure are further described in more detail with reference to the accompanying drawings. However, the disclosure may be embodied in many other forms and should not be construed as limited to any certain structure or function discussed in the following description. In contrast, these embodiments are provided to make the description of the disclosure detailed and complete.

According to the detailed description, it will be apparent to the ones skilled in the art that the scope of the disclosure encompasses any embodiment thereof, which is disclosed herein, irrespective of whether this embodiment is implemented independently or in concert with any other embodiment of the disclosure. For example, the apparatus and method disclosed herein may be implemented in practice by using any numbers of the embodiments provided herein. Furthermore, it should be understood that any embodiment of the disclosure may be implemented using one or more of the elements presented in the appended claims.

The word "exemplary" is used herein in the meaning of "used as an illustration". Unless otherwise stated, any embodiment described herein as "exemplary" should not be construed as preferable or having an advantage over other embodiments.

According to the exemplary embodiments disclosed herein, a user equipment or UE for short may refer to a mobile device, a mobile station, a terminal, a subscriber unit, a mobile phone, a cellular phone, a smart phone, a cordless phone, a personal digital assistant (PDA), a wireless communication device, a desktop computer, a laptop computer, a tablet computer, a gaming device, a netbook, a smartbook, an ultrabook, a medical device or medical equipment, a biometric sensor, a wearable device (for example, a smart watch, smart glasses, a smart wrist band, etc.), an entertainment device (for example, an audio player, a video player, etc.), a vehicular component or sensor, a smart meter/sensor, an unmanned vehicle (e.g., an industrial robot, a quadcopter, etc.), industrial manufacturing equipment, a global positioning system (GPS) device, an Internet-of-Things (IoT) device, an Industrial IoT (IIoT) device, a machine-type communication (MTC) device, a group of Massive IoT (MIoT) or Massive MTC (mMTC) devices/sensors, or any other suitable device configured to support wireless communications. In some embodiments, the UE may refer to at least two collocated and inter-connected UEs thus defined.

As used in the exemplary embodiments disclosed herein, a Radio Access Network node or RAN node for short may relate to a fixed point of communication for the UE in a particular wireless communication network. The RAN node may be referred to as a base transceiver station (BTS) in terms of the 2G communication technology, a NodeB in terms of the 3G communication technology, an evolved NodeB (eNodeB) in terms of the 4G communication technology, and a gNB in terms of the 5G New Radio (NR) communication technology. The RAN node may serve different cells, such as a macrocell, a microcell, a picocell, a femtocell, and/or other types of cells. The macrocell may cover a relatively large geographic area (for example, at least several kilometers in radius). The microcell may cover a geographic area less than two kilometers in radius, for example. The picocell may cover a relatively small geographic area, such, for example, as offices, shopping malls, train stations, stock exchanges, etc. The femtocell may cover an even smaller geographic area (for example, a home). Correspondingly, the RAN node serving the macrocell may be referred to as a macro node, the RAN node serving the microcell may be referred to as a micro node, and so on.

According to the exemplary embodiments disclosed herein, a wireless communication network, in which the UE and the RAN node communicate with each other, may refer to a cellular or mobile telecommunications network, a Wireless Local Area Network (WLAN), a Wireless Personal Area Networks (WPAN), a Wireless Wide Area Network (WWAN), a satellite communication (SATCOM) system, or any other type of wireless communication networks. Each of these types of wireless communication networks supports wireless communications according to one or more communication protocol standards. For example, the cellular network may operate according to the Global System for Mobile Communications (GSM) standard, the Code-Division Multiple Access (CDMA) standard, the Wide-Band Code-Division Multiple Access (WCDM) standard, the Time-Division Multiple Access (TDMA) standard, or any other communication protocol standard, the WLAN may operate according to one or more versions of the IEEE 802.11 standards, the WPAN may operate according to the Infrared Data Association (IrDA), Wireless USB, Bluetooth, or ZigBee standard, and the WWAN may operate according to the Worldwide Interoperability for Microwave Access (WiMAX) standard.

As used in the exemplary embodiments disclosed herein, a wireless communication system may refer to a set of at least two entities (e.g., one UE and one RAN node, two UEs, two RAN nodes, or the like) that are configured to intercommunicate via any wireless communication network (like the one described above). Said intercommunication may be performed via a radio channel established between, for example, a UE and a gNB. To achieve very high data rates for data transmissions, a MIMO approach may be applied to the radio channel. The MIMO approach involves employing multiple transmit antennas and multiple receive antennas (i.e. a MIMO channel) for data transmission. The MIMO channel formed by the multiple transmit and receive antennas may be decomposed into independent channels. Each of the independent channels may be also referred to as a spatial subchannel or a spatial or MIMO layer of the MIMO channel. The MIMO approach makes it possible to perform spatial multiplexing or spatial diversity. The spatial multiplexing refers to the transmission of multiple data streams simultaneously via multiple spatial layers of the MIMO channel.

The propagation phenomena that occur on the radio channel often cause large imbalances among the Signal-to-Noise Ratios (SNRs) of the MIMO layers. Large SNR imbalances may cause performance degradations. Table 1 given below shows an example of MIMO layer SNRs for a different number of NR Physical Downlink Shared Channel (PDSCH) transmissions. Each PDSCH transmission is assumed to have a different number of MIMO layers available therefor. The number of MIMO layers depends on the radio channel. In Table 1, cells which are not filled with any numbers imply that the associated MIMO layers are not available in the corresponding PDSCH transmission. In the NR, only one channel quality (e.g., SNR) is reported for multiple MIMO layers and only one modulation and code rate are used for transmission on the MIMO layers. Thus, the transmission performance of the whole MIMO channel is limited by the lowest quality among the MIMO layers (e.g., for the initial transmission in the example given in Table 1, it is 8.6 dB which represents the SNR of layer 4).

Table 1. Example of MIMO layers SNRs in an NR MIMO transmission.

| Transmission # | Layer 1 SNR [dB] | Layer 2 SNR [dB] | Layer 3 SNR [dB] | Layer 4 SNR [dB] |
|---|---|---|---|---|
| 1 | 27.7 | 19.7 | 11.9 | 8.6 |
| 2 | 27.8 | 20.2 | 15.3 | 10.6 |
| 3 | 29.4 | 24.1 | 12.6 | - |
| 4 | 30.2 | 17.8 | - | - |
| 5 | 32.7 | 25.8 | 20.5 | 14.1 |

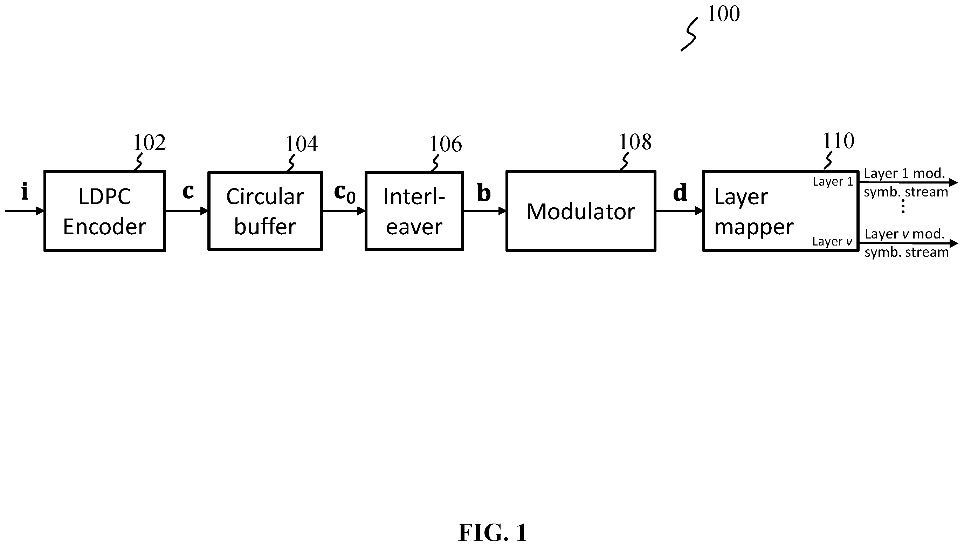

FIG. 1 shows a block diagram of a conventional transmitter 100 used to perform NR LDPC-coded transmission. The transmitter 100 may be part of a wireless communication apparatus, such, for example, as a UE or a gNB. As shown in FIG. 1, the transmitter 100 comprises an LDPC encoder 102, a circular buffer 104, an interleaver 106, a modulator 108, and a layer mapper 110, which are used in the transmitter 100 in the order they are mentioned. It should be noted that, in the NR, any data stream exchanged, for example, between the gNB and the UE consists of a sequence of data blocks. The data blocks are processed by the transmitter 100 independently from each other. More specifically, each data block is independently encoded by the LDPC encoder 102 using an error correction code (i.e. an LDPC code in this case), interleaved by the interleaver 106, modulated by the modulator 108 and mapped by the layer mapper 110 to $v$ MIMO layers, as shown in FIG. 1.

Let us now consider the operation of the transmitter 100 in more detail.

The LDPC encoder 102 maps a data block i = ($i_1$, ... , $i_K$) to a codeword c = ($c_1$, ... , $c_N$). The codeword c is written to the circular buffer 104 in the transmitter 100. In an initial transmission, a first codeword segment $c_0$ = ($c_e$, e = 1, ..., E), E > K, is read from the circular buffer 104 and sent to the interleaver 106 where it is subjected to bit interleaving or, in other words, bit rearrangement or swapping. Thus, the initial transmission has an error correction code rate equal to $R_C = K/E$.

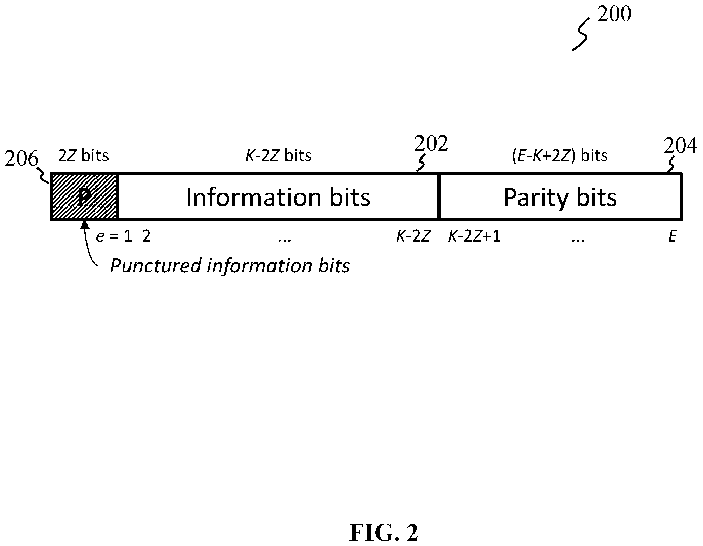

FIG. 2 shows an exemplary structure 200 of the first codeword segment $c_0$ for the initial transmission performed by the transmitter 100. As shown in FIG. 2, the first codeword segment $c_0$ consists of two main parts: a first part 202 containing information bits (conventionally called systematic bits) and a second part 204 containing parity bits (also called parity-check bits). The first codeword segment $c_0$ may be optionally obtained by removing or puncturing a part of the information bits in order to accelerate LDPC decoder convergence. Such a part of removed or punctured bits is denoted as "206" in FIG. 2. In general, the first codeword segment $c_0$ can be written as:

$$c_0 = (c_1, c_2, \ldots, c_E) = (j_1, j_2, \ldots, j_{K-2Z}, p_1, \ldots, p_{E-K+2Z}),$$

where $j_1 = i_{2Z+1}$, $j_2 = i_{2Z+2}$, ... , $j_{K-2Z} = i_K$ are the information bits, and $p_1, \ldots, p_{E-K+2Z}$ are the parity bits. The initial $2Z$ information bits (here, $Z$ denotes a lifting factor used to lift a parity check matrix of a given LDPC code) are punctured, i.e. represent the punctured bits which are neither written to the circular buffer 104 nor transmitted by the transmitter 100.

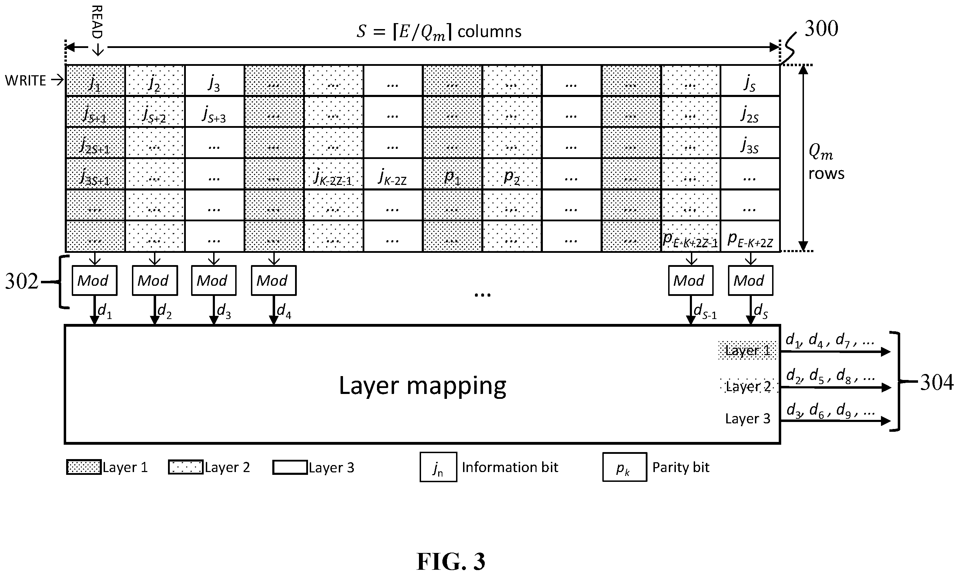

FIG. 3 explains the interleaving, modulation and layer-mapping operations performed in the transmitter 100. As follows from FIG. 3, the interleaver 106 uses a rectangular array or matrix 300 (which is also referred to as an interleaving matrix) with a number of rows equal to a modulation order $Q_m$ of a pre-selected modulation scheme and a number of columns $S = E/Q_m$. The bits of $c_0$ are written into the matrix 300 row-wise, left to right, starting from the top row. As the initial part of $c_0$ comprises the $(K - 2Z)$ information bits, the $\lfloor (K - 2Z)/S \rfloor$ top rows are filled with the information bits. The remaining information bits, if any, are written into the $\left( \left\lfloor \frac{K-2Z}{S} \right\rfloor + 1 \right)$-th row. The rest of the matrix 300 is filled with the parity bits.

Once the bits of $c_0$ are all written into the matrix 300, they are read from the matrix 300 column-wise, top to bottom, starting from the left-most column, thereby producing an output $b = (b_1, \ldots, b_E)$ of the interleaver 106. The $n$-th output bit of the interleaver 106 is therefore $b_n = C((n-1) \bmod Q_m)S + \lfloor n/Q_m \rfloor + 1$, where $mod$ denotes the modulo operation. The s-th column (where $s = 1, \ldots, S$) of the interleaver 106 produces a $Q_m$-tuple of bits $(b_{Q_m(s-1)+1}, b_{Q_m(s-2)+2}, \ldots, b_{Q_m s})$ which is then mapped to a complex modulation symbol $d_s$. It therefore turns out that the initial bits of any $Q_m$-tuple are the information bits. Given that the bits in a $Q_m$-tuple are provided with non-increasing levels of reliability, this yields that the information bits are mapped to high-capacity bit channels. Each bit channel may be considered as a physical resource used to convey a codeword bit to a receiver by mapping the codeword bit to a modulation symbol. The modulator 108 thus produces a modulation symbol vector $d = (d_1, \ldots, d_S)$, which is denoted as 302 in FIG. 3.

The layer mapper 110 maps the modulation symbols 302 from d to $v$ MIMO layers 304, where $1 \leq v \leq 4$. More specifically, the layer mapper 110 forms $v$ modulation symbol vectors - one for each MIMO layer, where the $l$-th vector can be written as $d_l = (d_l, d_{l+v}, d_{l+2v}, \ldots)$, $l = 1, \ldots, v$. It should be noted that the columns of the matrix 300 which are related to the same MIMO layer are shown in FIG. 3 by using the same dotted-pattern fill (e.g., the columns provided with the densest dotted-pattern fill correspond to MIMO layer 1). In further steps (not shown in FIG. 3), the layer-mapped symbols are pre-coded and mapped to time-frequency resource elements, then modulated, for example, by using Orthogonal Frequency Division Multiplexing (OFDM), and transmitted to the receiver, for example, of another UE or gNB.

The above-described transmission procedure for the first codeword segment $c_0$ is further repeated in respect of the rest (overlapping and/or non-overlapping) codeword segments of the codeword c one by one. More specifically, each subsequent codeword segment is read from the circular buffer 104, interleaved by using the matrix 300, and mapped to the corresponding modulation symbol vector 302 which, in turn, is mapped to the MIMO layers 304 in order to be transmitted to the receiver.

According to the above-described transmission procedure, the first codeword segment $c_0$ is transmitted on a number of independent bit channels (where each bit channel is a physical resource corresponding to a bit in a $Q_m$-tuple of bits read from the matrix 300) whose capacity - called herein a bit capacity - is jointly determined by the bit position in the $Q_m$-tuple $(b_1, b_2, \ldots, b_{Q_m})$ that is used to select the modulation symbol $d_S$ and by the SNR of the corresponding MIMO layer. The bit capacity $\beta_l^{(Q_m)}(SNR)$ of the $l^{th}$ bit in the $Q_m$-tuple $(b_1, b_2, \ldots, b_{Q_m})$ is defined as the mutual information between that a given bit $b_l$ and a corresponding log-likelihood ratio (LLR) $\lambda_l$. It may be mathematically written as:

$$\beta_l^{(Q_m)}(SNR) = I(b_l, \lambda_l),$$

where $I(X, Y)$ denotes the mutual information between the random variables $X$ and $Y$, $l$ is the position of the bit in the $Q_m$-tuple ($l = 1, \ldots, Q_m$), and the log-likelihood ratio (LLR) $\lambda_l$ is defined as follows:

$$\lambda_l = \log \frac{P(b_l = 0 | y)}{P(b_l = 1 | y)},$$

where y = x + w is the modulation symbol received by the receiver, w is the additive white Gaussian noise (AWGN) with a variance $\sigma_G^2$, $P(b_l = 0|y)$ is the likelihood that the bit $b_l$ is 0 in y, and $P(b_l = 1|y)$ is the likelihood that the bit $b_l$ is 1 in y.

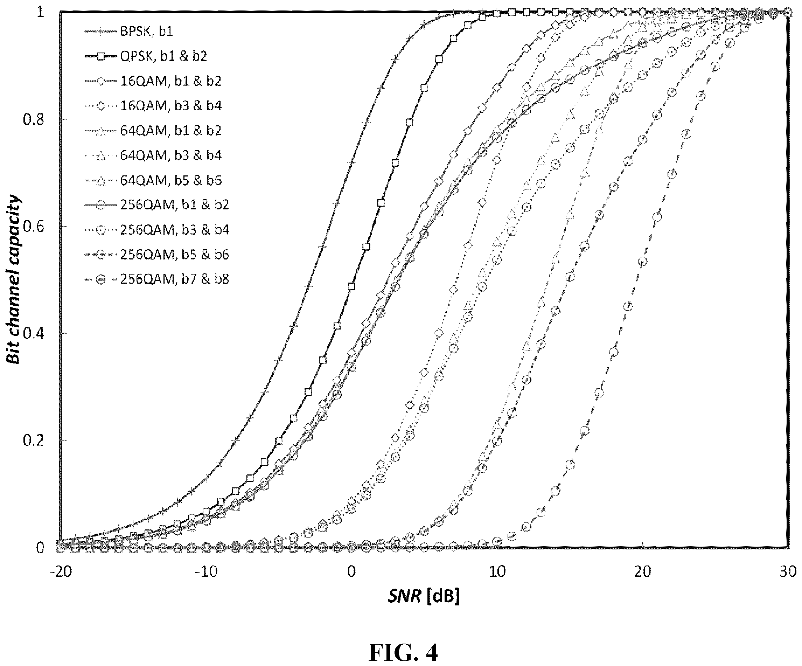

FIG. 4 shows dependences of bit capacities $\beta_l^{(Q_m)}$ on $SNR = 1/\sigma_G^2$ (assuming unit average modulation symbol energy) for different modulation schemes used in the transmitter 100. Here, $l \in \{1, ..., Q_m\}$ is the bit position in the $Q_m$-tuple. In particular, FIG. 4 shows the dependences $\beta_l^{(Q_m)}(SNR)$ for the following modulation schemes: BPSK ($Q_m = 1$), QPSK ($Q_m = 2$) and $2^{Q_m}$-QAM for $Q_m \in \{4,6,8\}$ (which corresponds to 16QAM, 64QAM and 256 QAM, respectively). As follows from FIG. 4, the bit channels $b_{Q_m s}$ corresponding to the initial positions in the $Q_m$-tuple of any $2^{Q_m}$-QAM modulation scheme correspond to the bit channels with the highest bit capacity. More precisely, for any *SNR*, any QAM modulation order $Q_m$ and bit positions $l_1, l_2 \in \{1, ..., Q_m\}$, $l_2 > l_1$, one can obtain $\beta_{l_1}^{(Q_m)}(SNR) \geq \beta_{l_2}^{(Q_m)}(SNR)$. It is also possible to write

$$\beta_1^{(Q_m)}(SNR) = \beta_2^{(Q_m)}(SNR) > \beta_3^{(Q_m)}(SNR) = \beta_4^{(Q_m)}(SNR) > \cdots$$

$$\cdots > \beta_{Q_m-1}^{(Q_m)}(SNR) = \beta_{Q_m}^{(Q_m)}(SNR).$$

Thus, the interleaver 106 maps the information bits to the high-capacity bit channels in each $Q_m$-tuple. However, the interleaver 106 neglects that the $Q_m$-tuples are then mapped to the MIMO layers 304 with different SNRs. As the SNR imbalance between the MIMO layers 304 may be large, mapping the information bits to the initial bits of the $Q_m$-tuple regardless of the layer SNR is not sufficient to guarantee a higher bit capacity to the information bits. In fact, when the SNR imbalance between the MIMO layers 304 is large, the last bits of one $Q_m$-tuple transmitted on the high-SNR MIMO layer have a higher capacity than the initial bits of another $Q_m$-tuple transmitted on the low-SNR MIMO layer.

To eliminate the above-mentioned drawback, the transmission of a single codeword on multiple MIMO layers could be replaced by the transmission of multiple shorter codewords, one for each MIMO layer or group of MIMO layers with similar SNRs. By so doing, each shorter codeword would be encoded and modulated using the best code rate and modulation order to match the layer SNR. However, this solution has the following major drawbacks:

1. the transmission of shorter codewords results in smaller coding gains compared to the transmission of long codewords;

2. scheduling multiple shorter codewords instead of a single codeword requires sending more scheduling messages on a control channel, thereby generating a larger amount of control information and causing potential control channel congestion.

The exemplary embodiments disclosed herein provide a technical solution that allows mitigating or even eliminating the above-sounded drawbacks peculiar to the prior art. In particular, the technical solution disclosed herein relates to a codeword bit interleaving scheme that involves dividing columns of an interleaving matrix (hereinafter referred to as a matrix for short) into at least two disjoint column groups based on transmission qualities (e.g., SNRs) of data transmission layers (e.g., MIMO layers). Two columns are in the same column group if the codeword bits are transmitted on the same layer or different layers with similar transmission qualities. The column groups are then filled with codeword bits, starting with writing information bits into the column group(s) corresponding to the high-quality data transmission layers. Once the information bits are all written, parity bits are then written into the rest column group(s). After that, the column groups are all merged to restore the initial column arrangement of the matrix, and the codeword bits are read from the matrix row-wise and mapped to modulation symbols. The modulation symbols are in turn mapped to the data transmission layers themselves. By so doing, it is possible to allocate information bits of a codeword to high-quality data transmission layers, thereby providing better decoding performance compared to the interleaver 106.

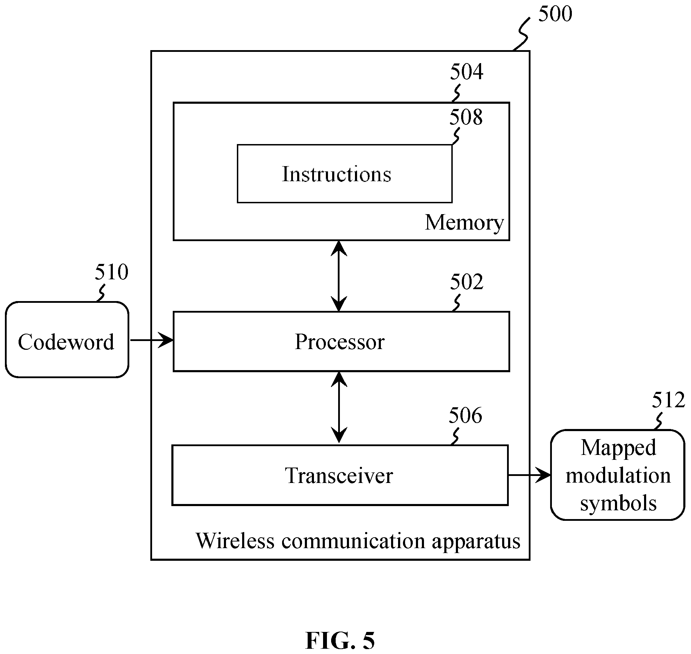

FIG. 5 shows a block diagram of a wireless communication apparatus 500 in accordance with one exemplary embodiment. The apparatus 500 may be implemented as a UE or RAN node or be part of the UE or RAN node. The apparatus 500 comprises a processor 502, a memory 504, and a transceiver 506. The memory 504 stores processor-executable instructions 508 which, when executed by the processor 502, cause the processor 502 to receive a codeword 510 and obtain layer-mapped modulation symbols 512, as will be described below in more detail. It should be noted that the number, arrangement and interconnection of the constructive elements constituting the apparatus 500, which are shown in FIG. 5, are not intended to be any limitation of the disclosure, but merely used to provide a general idea of how the constructive elements may be implemented within the apparatus 500. For example, the processor 502 may be replaced with several processors, as well as the memory 504 may be implemented as an individual storage device coupled to the apparatus 500. Furthermore, the transceiver 506 may be implemented as two devices, with one for a receiving operation and another for a transmitting operation. Irrespective of its implementation, the transceiver 506 is intended to be capable of performing different operations required to transmit the layer-mapped modulation symbols 512, such, for example, as OFDM-modulation, etc.

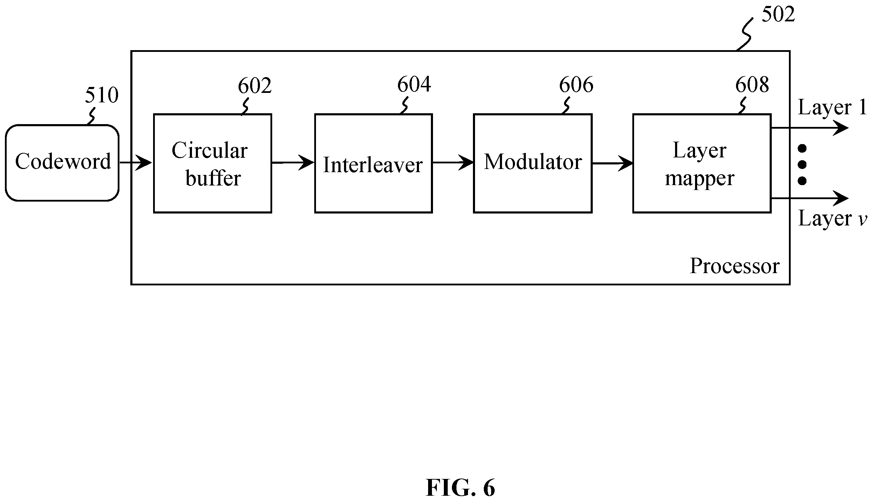

FIG. 6 shows a block diagram of the processor 502 in accordance with one exemplary embodiment. The processor 502 comprises the following components: a circular buffer 602, an interleaver 604, a modulator 606, and a layer mapper 608. The circular buffer 602, the interleaver 604, the modulator 606, and the layer mapper 608 are used for the same purposes as the circular buffer 104, the interleaver 106, the modulator 108, and the layer mapper 110, respectively, which are included in the transmitter 100 described above. The processor 502 may optionally comprise an encoder configured to obtain the codeword 510. The components of the processor 502 may be implemented as hardware and/or software. The hardware implementation of the components may be provided by using a CPU, general-purpose processor, single-purpose processor, microcontroller, microprocessor, application specific integrated circuit (ASIC), field programmable gate array (FPGA), digital signal processor (DSP), complex programmable logic device, or any combination thereof. As an example, the components of the processor 502 may be implemented as two or more microprocessors. The software implementation involves fulfilling the function of each component of the processor 502 by executing a corresponding code, program, routine, command, or the like, which is stored, for example, in the memory 504 together with the processor-executable instructions 506.

Referring back to FIG. 5, the memory 504 may be implemented as a classical nonvolatile or volatile memory used in the modern electronic computing machines. As an example, the nonvolatile memory may include Read-Only Memory (ROM), ferroelectric Random-Access Memory (RAM), Programmable ROM (PROM), Electrically Erasable PROM (EEPROM), solid state drive (SSD), flash memory, magnetic disk storage (such as hard drives and magnetic tapes), optical disc storage (such as CD, DVD and Blu-ray discs), etc. As for the volatile memory, examples thereof include Dynamic RAM, Synchronous DRAM (SDRAM), Double Data Rate SDRAM (DDR SDRAM), Static RAM, etc.

As for the processor-executable instructions 506 stored in the memory 504, they may be configured as a computer-executable code which causes the processor 502 to perform the aspects of the disclosure. The computer-executable code for carrying out operations or steps for the aspects of the disclosure may be written in any combination of one or more programming languages, such as Java, C++, or the like. In some examples, the computer-executable code may be in the form of a high-level language or in a pre-compiled form, and be generated by an interpreter (also pre-stored in the memory 504) on the fly.

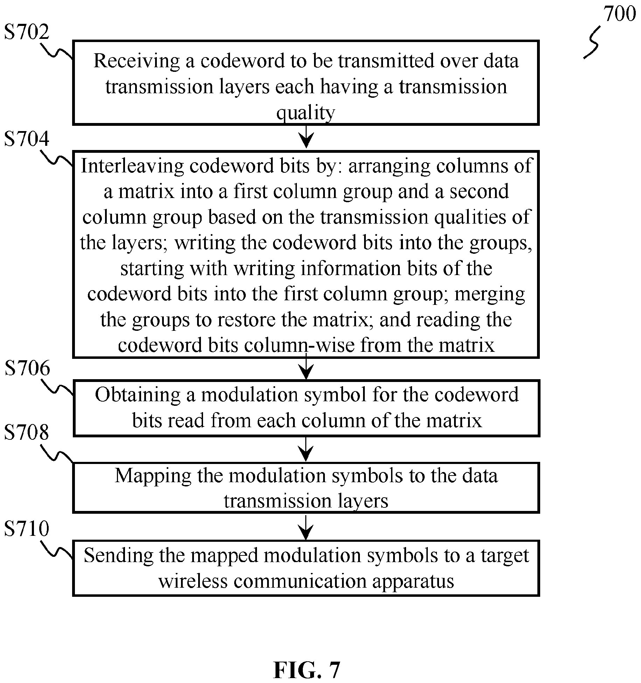

FIG. 7 shows a flowchart of a wireless communication method 700 in accordance with one exemplary embodiment. The method 700 as such describes the operation of the apparatus 500. As shown in FIG. 7, the method 700 starts with a step S702, in which the processor 502 receives the codeword 510 to be sent over data transmission layers. Each of the data transmission layers has a transmission quality. The data transmission layers may be represented by MIMO layers; however, the disclosure is not limited to this example, and those skilled in the art will easily recognize that the data transmission layers may refer to any spatial layers whereon information may be transmitted concurrently. As for the transmission quality, it may refer to any measure used in the art to compare a level of a desired signal to a level of background noise. One non-restrictive example of the transmission quality is a SNR. Relative to the codeword 510, it may be either obtained by the processor 502 itself, or received by the processor 502 from outside (e.g., from a remote server configured to send the codeword 510 to the transceiver 506 which in turn provides it to the processor 502). The codeword is obtained using a linear code. Non-restrictive examples of the linear code include a turbo code, a systematic code, a systematic polar code, a LDPC code, etc. The codeword 510 has a codeword length $E$ and comprises codeword bits. The codeword bits comprise at least one information bit and at least one parity bit. The step S702 may also involve storing the codeword 510 in the circular buffer 602 if its segmental transmission is scheduled.

Once the codeword 510 is received, the method 700 proceeds to a step S704, in which the processor 502, i.e. the interleaver 604, interleaves (or, in other words, rearrange/swap) the codeword bits of the codeword 510 by using a matrix with $n$ rows and $k$ columns, where $n$ and $k$ are selected based on a predefined modulation scheme and the codeword length $E$. The matrix may be created in the same manner as the matrix 300 used by the interleaver 106 of the transmitter 100. In general, $n$ may be equal to the modulation order $Q_m$ of the predefined modulation scheme, while k is obtained by applying a floor or ceiling function to a ratio of the codeword length E to the modulation order $Q_m$. Non-restrictive examples of the predefined modulation scheme include a QAM scheme, a PSK modulation scheme, and a QPSK modulation scheme, etc. Each of the columns of the matrix used in the step S704 of the method 700 corresponds to one of the data transmission layers, which makes it possible to group the columns based on the transmission qualities of the data transmission layers, as described below.

The interleaving step S704 itself is performed as follows. At first, the interleaver 604 arranges, into at least one first column group, the columns corresponding to the data transmission layers whose transmission qualities are equal to or above a threshold, and arranges, into at least one second column group, the columns corresponding to the data transmission layers whose transmission qualities are below the threshold. The threshold depends on particular application and may be any transmission quality value between the minimum transmission quality and the maximum transmission quality of the data transmission layers (e.g., any SNR between the minimum and maximum SNRs of the available MIMO layers to be used for transmission). Then, the interleaver 604 writes the codeword bits row-wise into the first column group(s) and the second column group(s), starting with writing the information bits row-wise into the first column group(s). After that, the interleaver 604 merges the first column group(s) and the second column group(s) to restore the matrix. Said restoration implies a return to the initial column arrangement in the matrix but now with the columns filled with the codeword bits. The interleaving step S704 is finished when the interleaver 604 reads the codeword bits column-wise from the matrix.

When the interleaving step S704 is finished, the method 700 proceeds to a step S706, in which the processor 502, i.e. the modulator 606, obtains, by using the predefined modulation scheme, a modulation symbol for the codeword bits read from each column of the matrix. After that, a next step S708 of the method 700 is initiated, in which the processor 502, i.e. the layer mapper 608, maps the modulation symbols obtained in the step S706 to the data transmission layers. Next, the method 700 goes on to a step S710, in which the transceiver 506 sends the mapped modulation symbols to a target wireless communication apparatus (e.g., another UE or gNB).

In one exemplary embodiment, the method 700 may comprise a further step, in which the processor 502 (e.g., a special additional hardware or software component included therein) determines the transmission qualities of the data transmission layers in advance, i.e. before the step S702 or the step S704, based on uplink reference signals in case of TDD communications or downlink reference signals in case of FDD communications. For example, if the apparatus 500 is a gNB which uses the MIMO approach when performing the TDD communications, downlink/uplink channel reciprocity is assumed, for which reason the gNB determines downlink SNRs by computing a singular value decomposition of a MIMO channel matrix obtained based on uplink reference signals. If the apparatus 500 is a UE which performs the FDD communications, the UE performs channel estimation, i.e. determines SNRs, based on downlink reference signals.

In one exemplary embodiment, the method 700 may comprise a further step, in which the processor 502 (e.g., a special additional hardware or software component included therein) determines, before the interleaving step S704, the modulation order $Q_m$ of the predefined modulation scheme based on the transmission qualities of the data transmission layers. By so doing, it is possible to select the modulation order $Q_m$ more suitable for the given data transmission layers, thereby increasing the efficiency of the interleaving step S704.

In one exemplary embodiment, the predefined modulation scheme may define a mapping of a $Q_m$-tuple of the codeword bits to be read, in the interleaving step S704, from each column of the matrix to the modulation symbol. In this embodiment, the method 700 may comprise further steps, in which the processor 502 (e.g., a special additional hardware or software component included therein) determines bit capacities of the codeword bits in each $Q_m$-tuple based on the transmission qualities of the data transmission layers, and uses the determined bit capacities to determine: (i) a number G of the first column group(s) and the second column group(s) into which the columns of the matrix are to be arranged, and (ii) a correspondence of each of the data transmission layers to the first column group(s) or the second column group(s). By so doing, it is possible to increase the efficiency of grouping the columns of the matrix used in the interleaving step S704, thereby increasing the efficiency of the interleaving step S704 itself.

In one exemplary embodiment, the method 700 may comprise, before the sending step S710, a further step, in which the processor 502 (e.g., a special additional hardware or software component included therein) generates and sends a control message to the target wireless communication apparatus. The control message may comprise at least one of the following: the modulation order $Q_m$; the codeword length $E$; the number G of the at least one first column group and the at least one second column group used when interleaving the codeword bits; and the correspondence of each of the data transmission layers to the at least one first column group or the at least one second column group. By so doing, it is possible to provide the target wireless communication apparatus with information about the codeword bit interleaving scheme used by the apparatus 100 when performing the method 700, thereby allowing the target wireless communication apparatus to deinterleave and, consequently, decode the codeword bits more efficiently and faster.

Such a control message may be sent to the target communication apparatus by using the following three control signaling methods:

1) According to the first control signaling method, a column grouping configuration g = $(\gamma_1, \ldots , \gamma_v)$ which indicates the column groups is signaled in a control field included in the control message. Each element $\gamma_v$ is an integer between 1 and the number $G$ of column groups, which indicates the column group for the corresponding column. For example, the interleaver 604 configured with $G = 1$, g = (1, ...,1) coincides with the interleaver 106. The first control signaling method may produce a non-negligible control information overhead, as g can take $v^v$ different values, and a bit field of size at least $\lceil v \log_2 v \rceil$ bits is needed.

2) According to the second control signaling method, it is assumed that the wireless communication apparatus 100 and the target wireless communication apparatus are configured to sort the data transmission layers in the same order based on the layer SNRs which they have independently determined. Once the layers are sorted according to their SNRs, for each pair of adjacent layers a control bit indicated in the control message signals whether the two layers are in the same column group. As there are $v - 1$ pairs of adjacent layers, a control field of size $v - 1$ bits is sufficient. At the same time, the second control signaling method suffers from the following drawback: the wireless communication apparatus 100 and the target wireless communication apparatus might produce different layer SNR estimations which could result in different layer orders. However, the swapping of the layers occurs when the SNR difference between the two swapped layers is small, i.e. when the two layers correspond to the same column group. Two layers with large SNR difference are never swapped, because this would imply a large SNR estimation error. The swapping of the layers that will be assigned to the same column group is irrelevant for interleaving/deinterleaving, for which reason the second control signaling method works even with SNR estimation errors.

3) According to the third control signaling method, it is assumed that the wireless communication apparatus 100 and the target wireless communication apparatus are configured to sort the data transmission layers in the same order based on the layer SNRs which they have independently determined, so as to determine the same sequence of layers sorted according to their own SNRs. A control field signals the number $G$ of groups between 1 and $v$; the $G - 1$ largest SNR gaps between consecutive layers in the sorted sequence of layers are used as group-separation SNR boundaries. As there can be at most $v$ column groups, a control field of size $\log_2 v$ bits is sufficient to have in the control message.

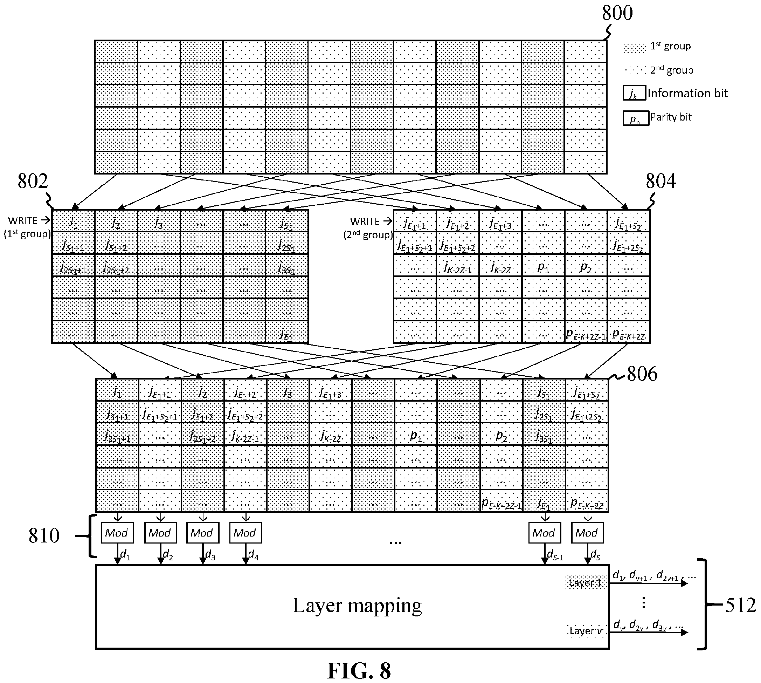

FIG. 8 explains the interleaving step S704, the modulation step S706 and the mapping step S708 of the method 700 in case of using two column groups. In the example shown in FIG. 8, a matrix 800 is created in the same manner as the matrix 300, i.e. it comprises $Q_m$ rows and $S = E/Q_m$ columns. Unlike the interleaver 106 (hereinafter referred to as the conventional interleaver 106 to highlight its relation to the prior art), the interleaver 604 divides the matrix 800 into a number $G = 2$ of disjoint column groups 802 and 804 in the step S704. It should be again noted that two columns are in the same column group if they correspond to the same layer or different layers with similar transmission qualities (e.g., SNRs). Similar to FIG. 3, the columns of the matrix 800 which are related to the corresponding layer are shown in FIG. 8 by using different dotted-pattern fills (e.g., the columns provided with the densest dotted-pattern fill correspond to layer 1). The column groups 802 and 804 may be arranged in the decreasing order of the transmission qualities of the corresponding layers. In FIG. 8, it is assumed that the first column group 802 is constituted by the columns of the matrix 800 which correspond the layers with higher transmission qualities (e.g., which are above a certain threshold in decibels (dB) in case if the transmission qualities are represented by SNRs).

Referring to FIG. 8, the codeword 510 is written into the matrix 800 in $G = 2$ steps. In the first step, the codeword bits $(c_1, c_2, ..., c_{E_1})$ are written into the first column group 802, starting with writing the information bits; here, $E_1$ is the total number of bits in the first column group 802. In the second step, the subsequent codeword bits $(c_{E_1+1}, c_{E_1+2}, ..., c_{E_1+E_2})$ are written into the second column group 804, where $E_2$ is the total number of bits in the 2nd column group. If more than two column groups are used, this procedure will continue until, in the last step, the remaining codeword bits are written into the G-th column group. In all steps, the codeword bits are written row-wise, left to right, into the matrix 800, starting from the top row.

Once the codeword bits of the codeword 510 are all written into the column groups 802 and 804, the interleaver 604 proceeds to merge the column groups 802 and 804 to restore the matrix 800, i.e. its initial column arrangement, which is denoted by 806 in FIG. 8. Reading the codeword bits from the restored matrix 806 is accomplished by the interleaver 604 in the same way as it is done by the conventional interleaver 106, i.e. the output b = $(b_1, ... , b_E)$ of the interleaver 604 is obtained by reading the restored matrix 806 column-wise, top to bottom, starting from the left-most column. The s-th column (s = 1, ...,S) of the restored matrix 806 produces a $Q_m$-tuple of bits $(b_{Q_m(s-1)+1}, b_{Q_m(s-1)+2}, ... , b_{Q_m s})$, which will be then mapped by the modulator 606 in the step S706 to a complex modulation symbol $d_s$. It therefore turns out that the initial bits of any $Q_m$-tuple represent the information bits. The modulator 606 produces a modulation symbol vector 810, i.e. d = $(d_1, ..., d_S)$, which is next mapped by the layer mapper 608 in the step S708 to the data transmission layers, thereby obtaining the layer-mapped modulation symbols 512.

If more than two column groups are formed in the interleaving step S704, and $v_g$ is used as a number of data transmission layers in the g-th column group (g = 1, ..., G), then $S_g = S v_g/v$ is the number of the columns of the matrix 800 in the g-th column group, and $E_g = S_g Q_m$ is the total number of bits in the g-th column group.

It should be noted that, if a single column group (i.e. $G = 1$) is used, the interleaver 604 writes the codeword bits into the matrix 800 in the same way as the conventional interleaver 106. In this case, reading the codeword bits from the matrix 800 is also done in the same way. Therefore, the interleaver 604 configured with one column group and the conventional interleaver 106 are exactly the same.

Whether, for the transmission of the codeword 510, it is convenient to use the conventional interleaver 106 or the interleaver 604 is determined based on a metric $\Delta_{CC}(\rho, g)$ which measures the total bit capacity increase in the codeword 510 (normalized by the codeword length $E$) that the interleaver 604 provides over the conventional interleaver 106. Here, $\rho = (SNR_1, \ldots, SNR_v)$ contains the layer SNRs (which are one example of the transmission qualities) and g $= (\gamma_1, \ldots, \gamma_v)$ indicates the column groups, as noted above. The definition of $\Delta_{CC}$ is given by

$$\Delta_{CC}(\rho, g) = \frac{1}{E} \sum_{e=1}^{K} \left[ \beta_{l_{604}(e)}^{(Q_m)}(SNR_{604}(e)) - \beta_{l_{106}(e)}^{(Q_m)}(SNR_{106}(e)) \right],$$

where the summation is computed over the information bit indices $e = 1, \ldots, K$ in the codeword 510, $\beta$ is the bit capacity that is defined as shown above when discussing FIG. 3; $l_{604}(e)$ gives the position of the $e$-th information bit in the $Q_m$-tuple when using the interleaver 604, $l_{106}(e)$ gives the position of the $e$-th information bit in the $Q_m$-tuple when using the conventional interleaver 106; $SNR_{604}(e)$ and $SNR_{106}(e)$ are the SNRs of the $e$-th information bit when using the interleaver 604 and the conventional interleaver 106, respectively. In the above equation, $\beta$ is independent of the interleaver used, whereas the interleavers' different mappings are captured by $l_{604}(e)$, $SNR_{604}(e)$ for the interleaver 604 and by $l_{106}(e)$, $SNR_{106}(e)$ for the conventional interleaver 106. $l_{106}(e)$ and $SNR_{106}(e)$ are obtained by applying the conventional interleaver mapping illustrated in FIG. 3. $l_{604}(e)$ and $SNR_{604}(e)$ are obtained by applying the interleaver mapping illustrated in FIG. 8.

Numerical evaluations have shown that $\Delta_{CC}$ provides a good indication of the gain obtained by the interleaver 604 - when $\Delta_{CC}$ is positive, the interleaver 604 has better performance than the conventional interleaver 106, whereas the negative $\Delta_{CC}$ indicates that the conventional interleaver 106 has better performance. Therefore, the interleaver selection may be made based on the sign of $\Delta_{CC}$.

Let us now consider one numerical example that explains how to use $\Delta_{CC}$.

Assume that the codeword 510 is obtained by using an LDPC code, and it is required to perform the segmental transmission of the codeword 510 with a code rate $R_C = 1/2$ by using the 16QAM $(Q_m = 4)$ on two data transmission layers $(v = 2)$ (e.g., MIMO layers). The average SNR is assumed to be 7 dB. Further assume that, in the first transmission of one codeword segment of the codeword 510, there is a small SNR difference of $\Delta_{SNR} = 2$ dB between the two layers - $SNR_1 = 8$ dB and $SNR_2 = 6$ dB, whereas, in the second transmission of another codeword segment of the codeword 510, the SNR difference between the two layers is $\Delta_{SNR} = 10$ dB - $SNR_1 = 12$ dB, $SNR_2 = 2$ dB. The interleaver 604 produces two column groups, each containing one column (i.e. g = (1,2)). Table 2 given below summarizes the above evaluation assumptions.

Table 2. Evaluations in the above numerical example.

| Transmission # | Code rate $(R_C)$ | Modulation order $(Q_m)$ | Avg. SNR | Layer 1 SNR $(SNR_1)$ | Layer 2 SNR $(SNR_2)$ | $\Delta_{SNR}$ |
|---|---|---|---|---|---|---|
| 1 | ½ | 4 | 7 dB | 8 dB | 6 dB | 2 dB |
| 2 | ½ | 4 | 7 dB | 12 dB | 2 dB | 10 dB |

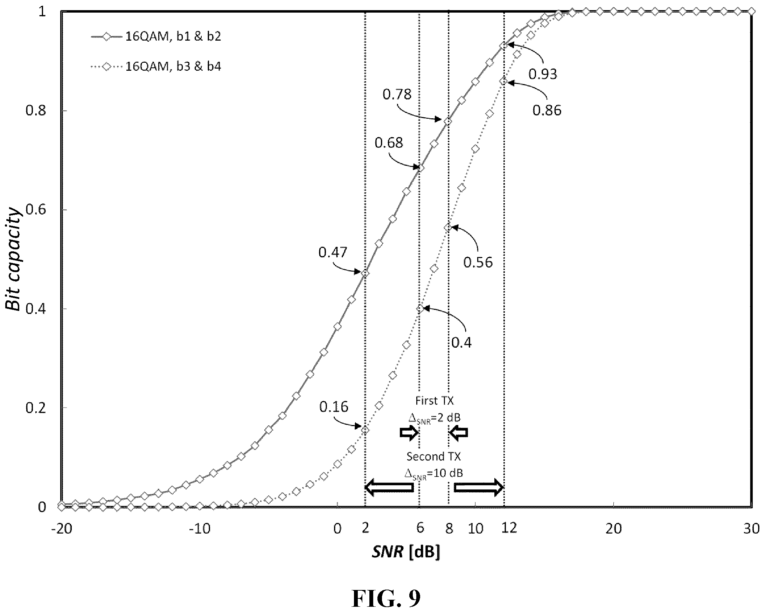

FIG. 9 shows dependencies $\beta_l^{(4)}(SNR)$, $l = 1, \ldots, 4$, for the above numerical example with the 16QAM $(Q_m = 4)$. In FIG. 9, pairs of vertical lines corresponding to the SNR differences between the two layers in case of the first and second transmissions intersect the dependences $\beta_l^{(4)}(SNR)$, thereby yielding the bit capacity of each codeword bit in each tuple of codeword bits. In this case, each 4-tuple of codeword bits is represented by four codeword bits b1, b2, b3, b4, where b1 is the first bit in the 4-tuple, b2 is the 2nd bit, and so on. In the first transmission, the bit capacity of the codeword bits b1 and b2 is 0.78 and the bit capacity of the codeword bits b3 and b4 is 0.56 in case of using the first data transmission layer, while the bit capacity of the code the bit capacity of the codeword bits b1 and b2 is 0.68 and the bit capacity of the codeword bits b3 and b4 is 0.4 in case of using the second data transmission layer. In the second transmission, the bit capacity of the codeword bits b1 and b2 is 0.93 and the bit capacity of the codeword bits b3 and b4 is 0.86 in case of using the first data transmission layer, while the bit capacity of the code the bit capacity of the codeword bits b1 and b2 is 0.47 and the bit capacity of the codeword bits b3 and b4 is 0.16 in case of using the second data transmission layer.

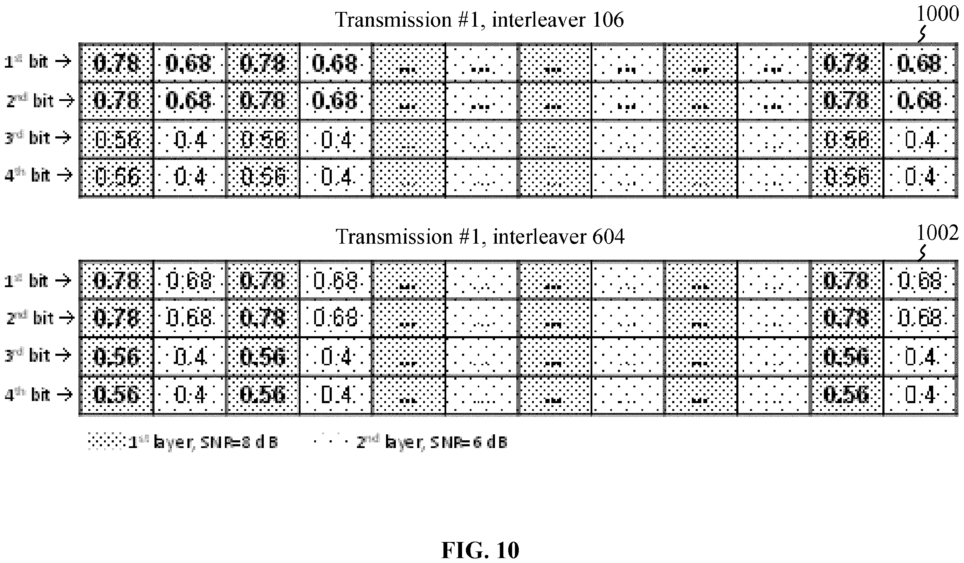

FIG. 10 shows matrices 1000 and 1002 used by the conventional interleaver 106 and the interleaving 604, respectively, and the corresponding bit capacities for the first transmission in the above numerical example. In FIG. 10, different dotted-pattern fills are again used to show the correspondence of the columns of the matrices 1000, 1002 to the two data transmission layers (e.g., the columns provided with the densest dotted-pattern correspond to the first data transmission layer). Moreover, boldface numbers indicate positions of information bits. As the code rate is 1/2, the information bits occupy half of each matrix regardless of the interleaver used. The conventional interleaver 106 writes the information bits row-wise into all columns (i.e., in other words, on the two data transmission layers), for which reason it fills the two higher rows with the information bits (see the upper part of FIG. 10). Therefore, one half of the information bits enjoy the bit capacity of 0.78 and another half enjoy the bit capacity of 0.68. Unlike the conventional interleaver 106, the interleaver 604 writes the information bits into the columns corresponding to the first data transmission layer only (see the lower part of FIG. 10). It means that one half of the information bits enjoy the bit capacity of 0.78 and another half enjoy the bit capacity of 0.56.

Let us now compute $\Delta_{CC}$ by applying the above equation. To do this, it is required to determine the positions $l_{604}(e)$ and $l_{106}(e)$ in the in $Q_m$-tuple and the values $SNR_{604}(e)$ and $SNR_{106}(e)$ of the data transmission layers on which the $e$-th bit is transmitted for each information bit ($e = 1, ... , K$). The values $l_{106}(e)$ and $SNR_{106}(e)$ are obtained by the interleaver mapping illustrated in FIG. 3; the corresponding bit capacities are determined from the upper part of FIG. 10. The values $l_{604}(e)$ and $SNR_{604}(e)$ are obtained by the interleaver mapping illustrated in FIG. 8; the corresponding bit capacities are determined from the lower part of FIG. 10. These values are shown in Table 3 below.

Table 3. Bit positions, SNRs and corresponding bit capacities for the first transmission.

| e | Interleaver 106 | | | Interleaver 604 | | | $\beta_{l_{604}}^{(4)}(SNR_{604}) - \beta_{l_{106}}^{(4)}(SNR_{106})$ |
|---|---|---|---|---|---|---|---|
| | $l_{106}$ | $SNR_{106}$ | $\beta_{l_{106}}^{(4)}(SNR_{106})$ | $l_{604}$ | $SNR_{604}$ | $\beta_{l_{604}}^{(4)}(SNR_{604})$ | |
| 1 | 1 | 8 | 0.78 | 1 | 8 | 0.78 | 0 |
| 2 | 1 | 6 | 0.68 | 1 | 8 | 0.78 | 0.1 |
| ... | ... | ... | ... | ... | ... | ... | ... |
| K/4-1 | 1 | 8 | 0.78 | 1 | 8 | 0.78 | 0 |
| K/4 | 1 | 6 | 0.68 | 1 | 8 | 0.78 | 0.1 |
| K/4 + 1 | 1 | 8 | 0.78 | 2 | 8 | 0.78 | 0 |
| K/4 + 2 | 1 | 6 | 0.68 | 2 | 8 | 0.78 | 0.1 |
| ... | ... | ... | ... | ... | ... | | ... |
| K/2 - 1 | 1 | 8 | 0.78 | 2 | 8 | 0.78 | 0 |
| K/2 | 1 | 6 | 0.68 | 2 | 8 | 0.78 | 0.1 |
| K/2 + 1 | 2 | 8 | 0.78 | 3 | 8 | 0.56 | -0.22 |
| K/2 + 2 | 2 | 6 | 0.68 | 3 | 8 | 0.56 | -0.12 |
| ... | ... | ... | ... | ... | ... | ... | ... |
| 3K/4 - 1 | 2 | 8 | 0.78 | 3 | 8 | 0.56 | -0.22 |
| 3K/4 | 2 | 6 | 0.68 | 3 | 8 | 0.56 | -0.12 |
| 3K/4 + 1 | 2 | 8 | 0.78 | 4 | 8 | 0.56 | -0.22 |
| 3K/4 + 2 | 2 | 6 | 0.68 | 4 | 8 | 0.56 | -0.12 |
| ... | ... | ... | ... | ... | ... | ... | ... |
| K-1 | 2 | 8 | 0.78 | 4 | 8 | 0.56 | -0.22 |
| K | 2 | 6 | 0.68 | 4 | 8 | 0.56 | -0.12 |

$\Delta_{CC}$ is obtained by summing the numbers in the rightmost column of Table 3 and dividing the results by $E$. In the rightmost column of Table 3, there are $K/4$ values = 0, $K/4$ values =0.1, $K/4$ values =-0.12 and $K/4$ values =-0.22. Therefore, $\Delta_{CC}$ for the first transmission is obtained as follows:

$$\Delta_{CC} = \frac{1}{E}\left[0 \times \frac{K}{4} + 0.1 \times \frac{K}{4} - 0.12 \times \frac{K}{4} - 0.22 \times \frac{K}{4}\right] = -0.03,$$

where $K/E = R_C$ = 1/2 has been used. The negative $\Delta_{CC}$ indicates that the conventional interleaver 106 provides better performance compared to the interleaver 604.

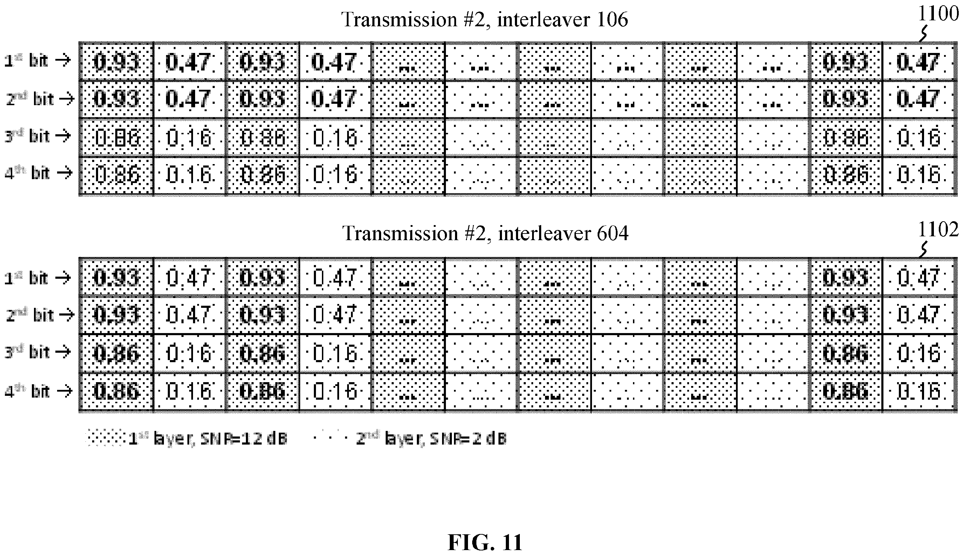

FIG. 11 shows matrices 1100 and 1102 used by the conventional interleaver 106 and the interleaving 604, respectively, and the corresponding bit capacities for the second transmission in the above numerical example. In FIG. 11, different dotted-pattern fills are again used to show the correspondence of the columns of the matrices 1100, 1102 to the two data transmission layers (e.g., the columns provided with the densest dotted-pattern correspond to the first data transmission layer). Moreover, boldface numbers again indicate the positions of the information bits. As follows from FIG. 11, in case of using the conventional interleaver 106, one half of the information bits enjoy the bit capacity of 0.93 and another half enjoy the bit capacity of 0.47. In case of using the interleaver 604, one half of the information bits enjoy the bit capacity of 0.93 and another half enjoy the bit capacity of 0.86. Similar to Table 3, Table 4 given below list the positions $l_{604}(e)$ and $l_{106}(e)$ in the $Q_m$-tuple, the values $SNR_{604}(e)$ and $SNR_{106}(e)$ of the two data transmission layers on which the e-th bit is transmitted ($e$ = 1, ... , K), as well as the bit capacities for the second transmission

Table 4. Bit positions, SNRs and corresponding bit capacities for the second transmission.

| $e$ | Interleaver 106 | | | Interleaver 604 | | | $\beta_{l_{604}}^{(4)}(SNR_{604})$ $- \beta_{l_{106}}^{(4)}(SNR_{106})$ |
|---|---|---|---|---|---|---|---|
| | $l_{106}$ | $SNR_{10}$ | $\beta_{l_{106}}^{(4)}(SNR_{106})$ | $l_{604}$ | $SNR_{604}$ | $\beta_{l_{604}}^{(4)}(SNR_{604})$ | |
| 1 | 1 | 12 | 0.93 | 1 | 12 | 0.93 | 0 |
| 2 | 1 | 2 | 0.47 | 1 | 12 | 0.93 | 0.46 |
| ... | ... | ... | ... | ... | ... | ... | ... |
| $K/4-1$ | 1 | 12 | 0.93 | 1 | 12 | 0.93 | 0 |
| $K/4$ | 1 | 2 | 0.47 | 1 | 12 | 0.93 | 0.46 |
| $K/4 + 1$ | 1 | 12 | 0.93 | 2 | 12 | 0.93 | 0 |
| $K/4 + 2$ | 1 | 2 | 0.47 | 2 | 12 | 0.93 | 0.46 |
| ... | ... | ... | ... | ... | ... | | ... |
| $K/2-1$ | 1 | 12 | 0.93 | 2 | 12 | 0.93 | 0 |
| $K/2$ | 1 | 2 | 0.47 | 2 | 12 | 0.93 | 0.46 |
| $K/2 + 1$ | 2 | 12 | 0.93 | 3 | 12 | 0.86 | -0.07 |
| $K/2 + 2$ | 2 | 2 | 0.47 | 3 | 12 | 0.86 | 0.39 |
| ... | ... | ... | ... | ... | ... | ... | ... |
| $3K/4 - 1$ | 2 | 12 | 0.93 | 3 | 12 | 0.86 | -0.07 |
| $3K/4$ | 2 | 2 | 0.47 | 3 | 12 | 0.86 | 0.39 |
| $3K/4 + 1$ | 2 | 12 | 0.93 | 4 | 12 | 0.86 | -0.07 |
| $3K/4 + 2$ | 2 | 2 | 0.47 | 4 | 12 | 0.86 | 0.39 |
| ... | ... | ... | ... | ... | ... | ... | ... |
| $K - 1$ | 2 | 12 | 0.93 | 4 | 12 | 0.86 | -0.07 |
| $K$ | 2 | 2 | 0.47 | 4 | 12 | 0.86 | 0.39 |

$\Delta_{CC}$ is obtained by summing the numbers in the rightmost column of Table 4 and dividing the results by $E$. In the rightmost column of Table 4, there are $K/4$ values = 0, $K/4$ values = 0.46, $K/4$ values = -0.07 and $K/4$ values = 0.39. Therefore, $\Delta_{CC}$ for the second transmission is obtained as follows:

$$\Delta_{\text{CC}} = \frac{1}{E}\left[0 \times \frac{K}{4} + 0.46 \times \frac{K}{4} - 0.07 \times \frac{K}{4} + 0.39 \times \frac{K}{4}\right] = 0.098.$$

The positive $\Delta_{\text{CC}}$ above indicates that the interleaver 604 provides better performance compared to the conventional interleaver 106.

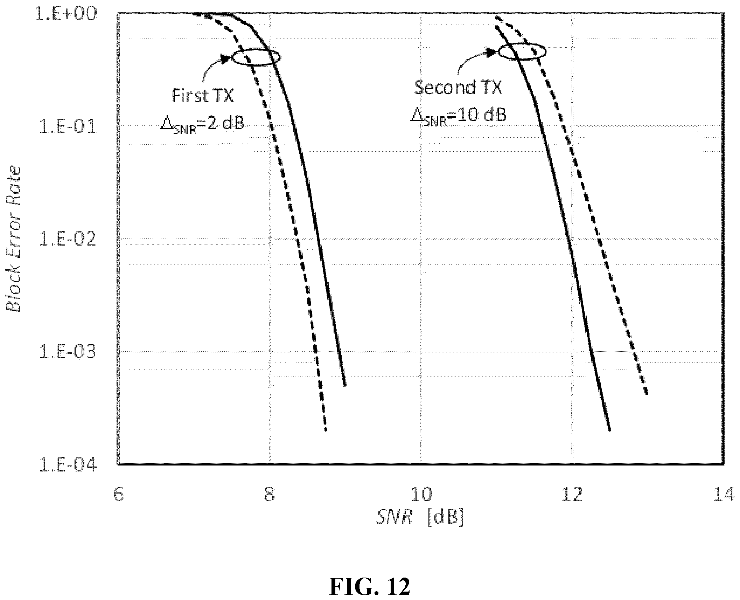

FIG. 12 shows dependencies of a Block Error Rate (BLER) on SNR for the two transmissions in the above numerical example. In FIG. 12, the dashed lines correspond to the conventional interleaver 106, while the solid lines correspond to the interleaver 604. The dependences BLER(SNR) confirm the above conclusions. For the first transmission (SNR = 8 dB), the conventional interleaver 106 has a smaller BLER than the interleaver 604. For the second transmission (SNR = 12 dB), the interleaver 604 provides a smaller BLER. It can be further concluded that data transmission layers with similar SNRs should be in the same column group, while data transmission layers with significantly different SNRs should be in separate column groups.

Thus, the above numerical example clearly shows how to decide on the conventional 106 and the interleaver 604 based on the sign of $\Delta_{\text{CC}}(\rho, g)$. At the same time, $\Delta_{\text{CC}}(\rho, g)$ allows one to find the best column grouping configuration g*. It can be done as follows:

$$g^*(\rho) = \arg\max_{g} \Delta_{\text{CC}}(\rho, g).$$

If the best column grouping obtained from the above equation turns out to be g* = (1, ...,1), all the columns are in the same column group, which means that the conventional interleaver 106 is the best choice, i.e. it provides the best performance. When g* ≠ (1, ...,1), the best performance is obtained by the interleaver 604 configured with the best column grouping g*.

Searching for the best column grouping configuration g* may be done numerically by computing $\Delta_{\text{CC}}(\rho, g)$ for all admitted column grouping configurations g. In general, as there are up to v column groups, each of the v elements of g can take a value between 1 and $v$. For a given column grouping configuration, this leads to a number of admitted values of the order of $v^v$ - a rather large number, even for small $v$. The searching complexity may be greatly reduced by recalling that only data transmission layers with similar SNRs may be in the same column group, as concluded above. Thus, the following searching strategy may be applied:

1. sorting the data transmission layers according to their SNRs;

2. for each pair of adjacent data transmission layers, evaluating whether they should be in the same column group or not.

As there are $v$ - 1 pairs of adjacent data transmission layers, the number of admitted column grouping configurations drops from $v^v$ to $2^{v-1}$. Therefore, it is required to evaluate $\Delta_{\text{CC}}(\rho, g)$ only for $2^{v-1}$ times. In the NR, the maximum number of MIMO layers (which are one example of the data transmission layers) for one codeword is $v = 4$. Therefore, the number of admitted column grouping configurations would be of the order of $v^v = 256$. With the above searching strategy, the number of admitted column grouping configurations is reduced to $2^{v-1} = 8$.

The performance of the LDPC-coded transmission in the above numerical example is evaluated on the MIMO channel with $v$ layers and with $G$ column groups where the MIMO layers have the same SNR within each column group. Without loss of generality, one may assume that the first column group has higher SNR than other column groups, and the $g$-th column group SNR is $\square_{\text{SNR},g}$ [dB] smaller than the SNR of the first column group. The channel model is represented by the additive white Gaussian noise (AWGN). The performance evaluation assumptions are summarized in Table 5 given below. The performance gain is evaluated based on the SNR needed to achieve the BLER ≤ $10^{-2}$.

Table 5. Summary of simulation parameters (a subset of combinations is evaluated).

| Parameter | Value |
|---|---|
| LDPC code rate ($R_C = K/E$) | ¼, ½, $^2/_3$ |
| Modulations | QPSK, 16QAM, 64QAM |
| Number of layers ($v$) | 2, 4 |
| Number or time-frequency REs | 80, 1024 |
| Channel model | AWGN |

(continued)

| Parameter | Value |
|---|---|
| SNR difference between layers $\square_{SNR,g}$ [dB] | 3, 6, 10, 12, 15, 18, 24 |
| LDPC decoder | Belief-propagation, 50 iterations |

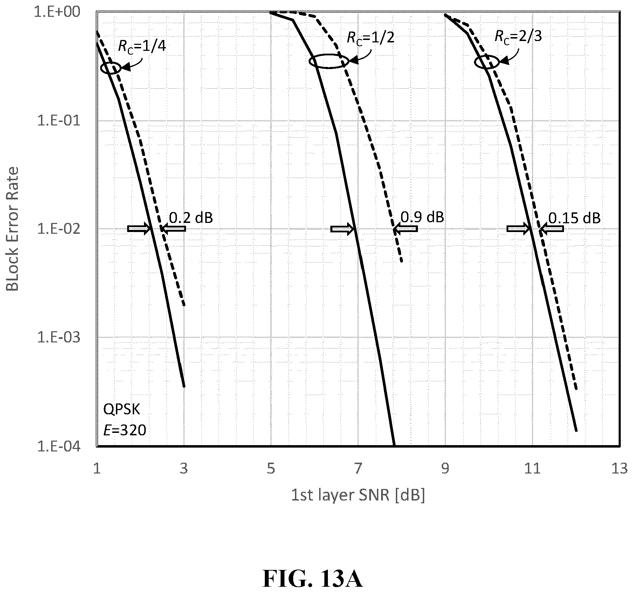

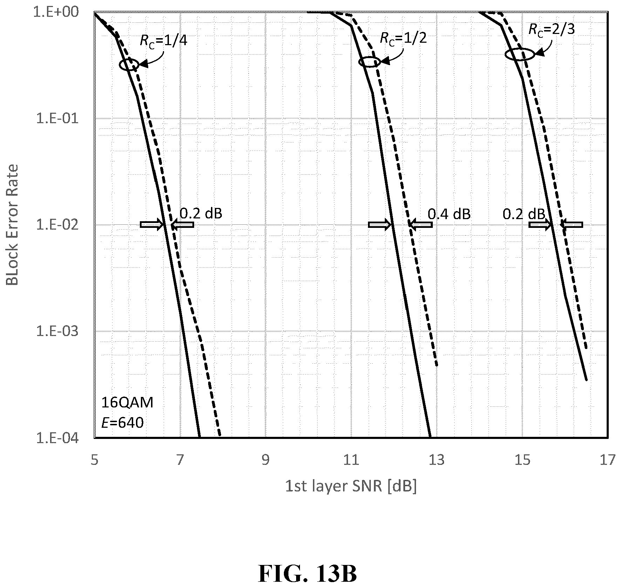

FIGs. 13A and 13B show the BLER performance of QPSK-modulated and 16QAM-modulated LDPC-coded transmission on $v$ = 2 MIMO layers and $6$ = 2 column groups. In FIGs. 13A and 13B, the solid curves show the performance obtained with the interleaver 604, while the dashed curves show the performance obtained with the conventional interleaver 106. The SNR difference between the MIMO layers is $\square_{SNR}$ = 10 dB. It can be observed that the interleaver 604 performs uniformly better than the conventional interleaver 106. SNR gains up to 0.9 dB are observed with the QPSK modulation and the LDPC code rate ½ (see FIG. 13A). SNR gains are slightly smaller but still significant with the 16QAM (see FIG. 13B).

It is observed in FIGs. 13A and 13B that higher order modulations provide lower gains. When the layer SNR difference is small, the conventional interleaver 106 already maps the information bits to the bit channels with the highest bit capacity. Thus, there is no gain. In order to have gains with a high-order modulation, the layer SNR difference must be large enough so that the smallest bit capacity on the high-SNR layer(s) is larger than the largest bit capacity on the low-SNR layer(s). Thus, for each modulation order, there is a minimum SNR difference below which the interleaver 604 provides no gain or even loss. That minimum SNR difference is 0 dB for the QPSK, roughly 6 dB for the 16QAM, and roughly 10 dB for the 64QAM. Therefore, for a given and fixed SNR difference, the higher the modulation order is, the smaller the gain is.

It is also observed in FIGs. 13A and 13B that, for any given modulation and given $D_{SNR}$, the largest gain is achieved with the code rate $R_C = \frac{K}{E} = \frac{1}{2}$, whereas the gain is smaller for code rates ¼ and 2/3. Such behaviour is connected to the fundamental observation that the best belief-propagation decoding performance is obtained when the information bits are mapped to the bit channels with the highest bit capacity.

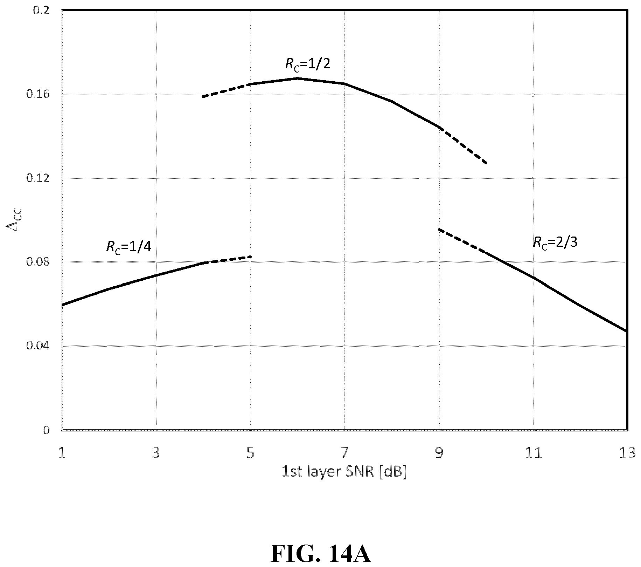

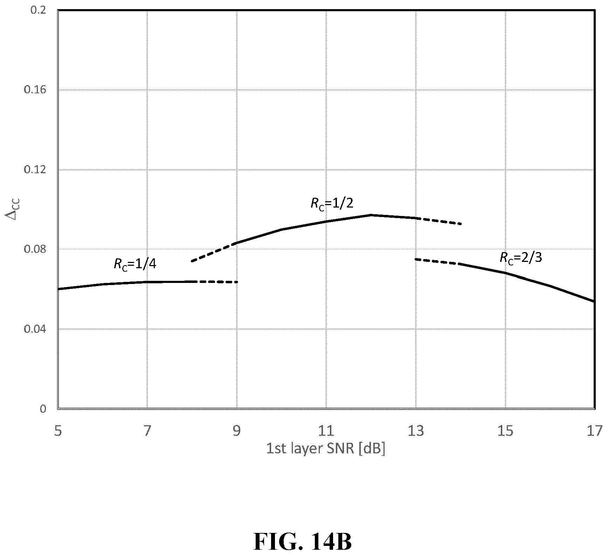

FIGs. 14A and 14B show $\Delta_{CC}$(SNR) for the same code rates and modulations as used for FIGs. 13A and 13B. The curve $\Delta_{CC}$(SNR) has multiple branches - one branch for each code rate. In FIGs. 14A and 14B, each branch is shown in the range of SNRs surrounding the SNR point at which the BLER = $10^{-2}$. It can be seen that $\Delta_{CC}$ for the branch corresponding to code rate 1/2 is higher than for the other branches. The comparison of FIGs. 13A, 13B and FIGs. 14A, 14B reveals a clear correlation between $\Delta_{CC}$ and the gain of the interleaver 604. For code rate 1/2, the gain and $\Delta_{CC}$ is larger than for other code rates. For higher-order modulations, $\Delta_{CC}$ depends on the code rate and the SNRs of all MIMO layers. This makes the derivation of the best code rate more difficult.

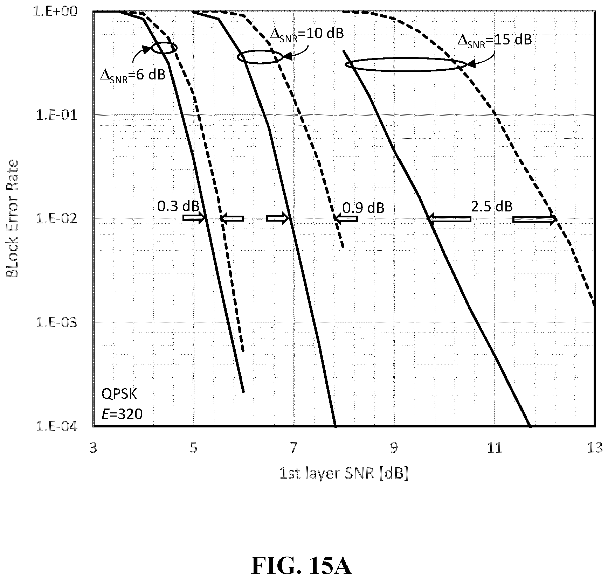

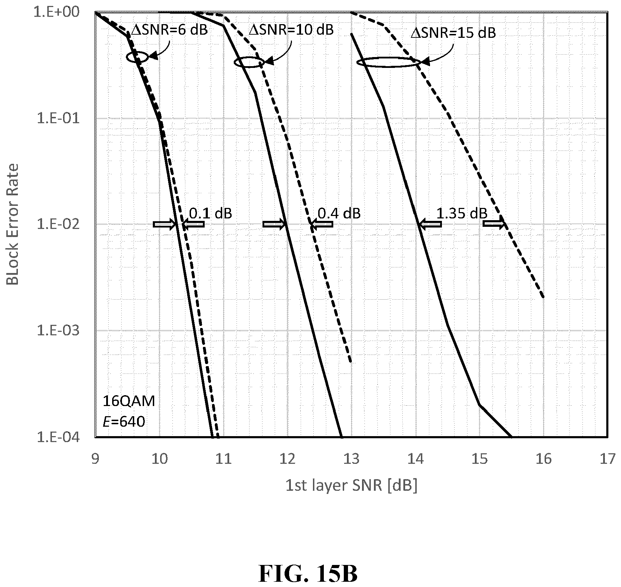

FIGs. 15A and 15B show the BLER performance of the QPSK-modulated and 16QAM-modulated LDPC-coded transmission for various layer SNR differences. In FIGs. 15A and 15B, the solid curves show the BLER performance obtained with the interleaver 604, while the dashed curves show the BLER performance obtained with the conventional interleaver 106. In this case, the code rate is $R_C$=1/2. The interleaver 604 performs uniformly better than the convention interleaver 106. SNR gains up to 2.7 dB are observed with the QPSK and $\square_{SNR}$ =15 dB (see FIG. 15A). With the 16QAM, SNR gains up to 1.7 dB are observed when $\square_{SNR}$ =15 dB (see FIG. 15B).

It should be noted that each step or operation of the method 700, or any combinations of the steps or operations, can be implemented by various means, such as hardware, firmware, and/or software. As an example, one or more of the steps or operations described above can be embodied by processor executable instructions, data structures, program modules, and other suitable data representations. Furthermore, the executable instructions which embody the steps or operations described above can be stored on a corresponding data carrier and executed by the processor 502. This data carrier can be implemented as any computer-readable storage medium configured to be readable by said at least one processor to execute the processor executable instructions. Such computer-readable storage media can include both volatile and nonvolatile media, removable and non-removable media. By way of example, and not limitation, the computer-readable media comprise media implemented in any method or technology suitable for storing information. In more detail, the practical examples of the computer-readable media include, but are not limited to information-delivery media, RAM, ROM, EEPROM, flash memory or other memory technology, CD-ROM, digital versatile discs (DVD), holographic media or other optical disc storage, magnetic tape, magnetic cassettes, magnetic disk storage, and other magnetic storage devices.

Although the exemplary embodiments of the disclosure are described herein, it should be noted that any various changes and modifications could be made in the embodiments of the disclosure, without departing from the scope of legal protection which is defined by the appended claims. In the appended claims, the word "comprising" does not exclude other elements or operations, and the indefinite article "a" or "an" does not exclude a plurality. The mere fact that certain measures are recited in mutually different dependent claims does not indicate that a combination of these measures cannot be used to advantage.

**Claims**

1.  An apparatus (500) for a wireless communication system, comprising:

    a processor (502);
    a memory (504) coupled to the processor (502) and configured to store processor-executable instructions (508), wherein the processor (502) is configured, when executing the processor-executable instructions (508), to:

    receive a codeword (510) to be sent over data transmission layers, wherein each of the data transmission layers has a transmission quality, the codeword (510) being obtained using a linear code, the codeword (510) having a codeword length $E$ and comprising codeword bits, the codeword bits comprising at least one information bit and at least one parity bit;
    interleave the codeword bits by using a matrix (800) with $n$ rows and $k$ columns, where $n$ and k are selected based on a predefined modulation scheme and the codeword length $E$, each of the columns corresponding to one of the data transmission layers, and said interleaving comprising:

    - arranging, into at least one first column group (802), the columns corresponding to the data transmission layers whose transmission qualities are equal to or above a threshold;
    - arranging, into at least one second column group (804), the columns corresponding to the data transmission layers whose transmission qualities are below the threshold;
    - writing the codeword bits row-wise into the at least one first column group (802) and the at least one second column group (804), starting with writing the at least one information bit row-wise into the at least one first column group (802);
    - merging the at least one first column group (802) and the at least one second column group (804) to restore the matrix (800); and
    - reading the codeword bits column-wise from the matrix (800);

    obtain, by using the predefined modulation scheme, a modulation symbol (810) for the codeword bits read from each column of the matrix; and
    map the modulation symbols (810) to the data transmission layers; and

    a transceiver (506) configured to send the mapped modulation symbols (512) to a target wireless communication apparatus,

    wherein the predefined modulation scheme has a modulation order $Q_m$, and wherein $n$ is equal to the modulation order $Q_m$, while $k$ is obtained by applying a floor or ceiling function to a ratio of the codeword length $E$ to the modulation order $Q_m$;
    wherein the predefined modulation scheme defines a mapping of a $Q_m$-tuple of the codeword bits for each column of the matrix (800) to the modulation symbol (810), and wherein the processor (502) is further configured to:

    determine bit capacities of the codeword bits in each $Q_m$-tuple based on the transmission qualities of the data transmission layers; and
    based on the determined bit capacities, determine: (i) a number G of the at least one first column group (802) and the at least one second column group (804) into which the columns of the matrix (800) are to be arranged, and (ii) a correspondence of each of the data transmission layers to the at least one first column group (802) or the at least one second column group (804); and

    wherein the processor (502) is further configured, before said causing the transceiver to send the mapped modulation symbols (512), to:

    generate a control message comprising at least one of:

    the modulation order $Q_m$;

the codeword length $E$;

the number $G$ of the at least one first column group (802) and the at least one second column group (804) used when interleaving the codeword bits; and

the correspondence of each of the data transmission layers to the at least one first column group (802) or the at least one second column group (804); and

cause the transceiver (506) to send the control message to the target wireless communication apparatus.

2. The apparatus (500) of claim 1, wherein the processor (502) is further configured, before said interleaving, to determine the modulation order $Q_m$ of the predefined modulation scheme based on the transmission qualities of the data transmission layers.

3. The apparatus (500) of claim 1 or 2, wherein the codeword (510) is obtained using the linear code selected from one of a turbo code, a systematic code, a systematic polar code, and a Low-Density Parity-Check, LDPC, code (200).

4. The apparatus (500) of any one of claims 1 to 3, wherein the predefined modulation scheme comprises one of a quadrature amplitude modulation, QAM, scheme, a Phase Shift Keying, PSK, modulation scheme, and a Quadrature PSK, QPSK, modulation scheme.

5. The apparatus (500) of any one of claims 1 to 4, wherein the processor (502) is further configured to determine the transmission qualities of the data transmission layers in advance based on uplink reference signals in case of Time-Division Duplexing, TDD, communications or downlink reference signals in case of Frequency-Division Duplexing, FDD, communications.

6. The apparatus (500) of any one of claims 1 to 8, wherein the data transmission layers comprise Multiple-Input Multiple-Output, MIMO, spatial layers.

7. A method (700) for wireless communications, comprising:

receiving (S702) a codeword (510) to be sent over data transmission layers, each of the data transmission layers having a transmission quality, the codeword (510) being obtained using a linear code, the codeword (510) having a codeword length $E$ and comprising codeword bits, the codeword bits comprising at least one information bit and at least one parity bit;

interleaving (S704) the codeword bits by using a matrix (800) with $n$ rows and $k$ columns, where $n$ and $k$ are selected based on a predefined modulation scheme and the codeword length $E$, each of the columns corresponding to one of the data transmission layers, and said interleaving (S704) comprising:

- arranging, into at least one first column group (802), the columns corresponding to the data transmission layers whose transmission qualities are equal to or above a threshold;
- arranging, into at least one second column group (804), the columns corresponding to the data transmission layers whose transmission qualities are below the threshold;
- writing the codeword bits row-wise into the at least one first column group (802) and the at least one second column group (804), starting with writing the at least one information bit row-wise into the at least one first column group (802);
- merging the at least one first column group (802) and the at least one second column group (804) to restore the matrix (800); and
- reading the codeword bits column-wise from the matrix (800);

obtaining (S706), by using the predefined modulation scheme, a modulation symbol (812) for the codeword bits read from each column of the matrix (800);

mapping (S708) the modulation symbols (810) to the data transmission layers; and

sending (S710) the mapped modulation symbols (512) to a target wireless communication apparatus,

wherein the predefined modulation scheme has a modulation order $Q_m$, and wherein $n$ is equal to the modulation order, $Q_m$, while $k$ is obtained by applying a floor or ceiling function to a ratio of the codeword length $E$ to the modulation order $Q_m$;

wherein the predefined modulation scheme defines a mapping of a $Q_m$-tuple of the codeword bits for each column of the matrix (800) to the modulation symbol (810), and wherein the method (700) further comprises:

determining bit capacities of the codeword bits in each $Q_m$-tuple based on the transmission qualities of the data transmission layers; and

based on the determined bit capacities, determining: (i) a number $G$ of the at least one first column group (802) and the at least one second column group (804) into which the columns of the matrix (800) are to be arranged, and (ii) a correspondence of each of the data transmission layers to the at least one first column group (802) or the at least one second column group (804);

wherein the method (700) further comprises, before said sending (S710) the mapped modulation symbols (512):

generating a control message comprising at least one of:

the modulation order $Q_m$;
the codeword length $E$;
the number $G$ of the at least one first column group (802) and the at least one second column group (804) used when interleaving the codeword bits; and
the correspondence of each of the data transmission layers to the at least one first column group (802) or the at least one second column group (804); and

sending the control message to the target wireless communication apparatus.

8. The method (700) of claim 7, further comprising, before said interleaving (S704), determining the modulation order $Q_m$ of the predefined modulation scheme based on the transmission qualities of the data transmission layers.

9. The method (700) of claim 7 or 8, wherein the codeword (510) is obtained using the linear code selected from one of a turbo code, a systematic code, a systematic polar code, and a Low-Density Parity-Check, LDPC, code (200).

10. The method (700) of any one of claims 7 to 9, wherein the predefined modulation scheme comprises one of a quadrature amplitude modulation, QAM, scheme, a Phase Shift Keying, PSK, modulation scheme, and a Quadrature PSK, QPSK, modulation scheme.

11. The method (700) of any one of claims 7 to 10, further comprising determining the transmission qualities of the data transmission layers in advance based on uplink reference signals in case of Time-Division Duplexing, TDD, communications or downlink reference signals in case of Frequency-Division Duplexing, FDD, communications.

12. The method (700) of any one of claims 7 to 11, wherein the data transmission layers comprise Multiple-Input Multiple-Output, MIMO, spatial layers.

13. A computer program product comprising a computer-readable storage medium, wherein the computer-readable storage medium comprises a computer code which, when executed by at least one processor, causes the at least one processor to perform the method (700) according to any one of claims 7 to 12.


**Patentansprüche**

1. Vorrichtung (500) für ein drahtloses Kommunikationssystem, umfassend:

einen Prozessor (502);
einen Speicher (504), der mit dem Prozessor (502) gekoppelt ist und konfiguriert ist zum Speichern von in einem Prozessor ausführbaren Befehlen (508), wobei der Prozessor (502), wenn er die in einem Prozessor ausführbaren Befehle (508) ausführt, konfiguriert ist zum:

Empfangen eines Codeworts (510), das über Datenübertragungsschichten gesendet werden soll, wobei jede der Datenübertragungsschichten eine Übertragungsqualität aufweist, wobei das Codewort (510) unter Verwendung eines linearen Codes erhalten wird, wobei das Codewort (510) eine Codewortlänge $E$ aufweist und Codewortbits umfasst, wobei die Codewortbits mindestens ein Informationsbit und mindestens ein Paritätsbit umfassen;
Verschachteln der Codewortbits, indem eine Matrix (800) mit $n$ Zeilen und $k$ Spalten verwendet wird, wobei $n$ und $k$ basierend auf einem vordefinierten Modulationsschema und der Codewortlänge $E$ ausgewählt werden, wobei jede der Spalten einer der Datenübertragungsschichten entspricht und wobei das Verschachteln umfasst:

- Anordnen, in mindestens einer ersten Spaltengruppe (802), der Spalten, die den Datenübertragungsschichten entsprechen, deren Übertragungsqualitäten gleich einem Schwellenwert sind oder über diesem liegen;
- Anordnen, in mindestens einer zweiten Spaltengruppe (804), der Spalten, die den Datenübertragungsschichten entsprechen, deren Übertragungsqualitäten unter dem Schwellenwert liegen;
- Schreiben der Codewortbits zeilenweise in die mindestens eine erste Spaltengruppe (802) und die mindestens eine zweite Spaltengruppe (804) beginnend mit dem Schreiben des mindestens einen Informationsbits zeilenweise in die mindestens eine erste Spaltengruppe (802);
- Zusammenführen der mindestens einen ersten Spaltengruppe (802) und der mindestens einen zweiten Spaltengruppe (804), um die Matrix (800) wiederherzustellen; und
- Lesen der Codewortbits spaltenweise aus der Matrix (800);

Erhalten, indem das vordefinierte Modulationsschema verwendet wird, eines Modulationssymbols (810) für die Codewortbits, die aus jeder Spalte der Matrix ausgelesen wurden; und

Zuordnen der Modulationssymbole (810) zu den Datenübertragungsschichten; und

einen Transceiver (506), der konfiguriert ist zum Senden der zugeordneten Modulationssymbole (512) zu einer drahtlosen Zielkommunikationsvorrichtung,

wobei das vordefinierte Modulationsschema eine Modulationsordnung $Q_m$, aufweist und wobei $n$ gleich der Modulationsordnung $Q_m$ ist, während k erhalten wird, indem eine Abrundungs- oder Aufrundungsfunktion auf ein Verhältnis der Codewortlänge $E$ zur Modulationsordnung $Q_m$ angewandt wird,

wobei das vordefinierte Modulationsschema eine Zuordnung eines $Q_m$-Tupel der Codewortbits für jede Spalte der Matrix (800) zu dem Modulationssymbol (810) definiert, und wobei der Prozessor (502) außerdem konfiguriert ist zum:

Ermitteln von Bitkapazitäten der Codewortbits in jedem $Q_m$-Tupel basierend auf den Übertragungsqualitäten der Datenübertragungsschichten; und

Ermitteln, basierend auf den ermittelten Bitkapazitäten: (i) einer Anzahl $G$ der mindestens einen ersten Spaltengruppe (802) und der mindestens einen zweiten Spaltengruppe (804), in welche die Spalten der Matrix (800) angeordnet werden sollen,

und (ii) einer Entsprechung von jeder der Datenübertragungsschichten mit der mindestens einen ersten Spaltengruppe (802) oder der mindestens einen zweiten Spaltengruppe (804); und

wobei der Prozessor (502), vor dem Veranlassen des Transceivers, die zugeordneten Modulationssymbole (512) zu senden, konfiguriert ist zum:

Erzeugen einer Steuernachricht, die mindestens eine umfasst von:

der Modulationsordnung $Q_m$;

der Codewortlänge $E$;

der Anzahl $G$ der mindestens einen ersten Spaltengruppe (802) und der mindestens einen zweiten Spaltengruppe (804), die verwendet wird, wenn die Codewortbits verschachtelt werden, und

der Entsprechung von jeder der Datenübertragungsschichten mit der mindestens einen ersten Spaltengruppe (802) oder der mindestens einen zweiten Spaltengruppe (804); und

Veranlassen des Transceivers (506) zum Senden der Steuernachricht zu der drahtlosen Zielkommunikationsvorrichtung.

2. Vorrichtung (500) nach Anspruch 1, wobei der Prozessor (502) vor dem Verschachteln außerdem konfiguriert ist zum Ermitteln der Modulationsordnung $Q_m$ des vordefinierten Modulationsschemas basierend auf den Übertragungsqualitäten der Datenübertragungsschichten.

3. Vorrichtung (500) nach Anspruch 1 oder 2, wobei das Codewort (510) unter Verwendung des linearen Codes erhalten wird, der ausgewählt wird aus einem von einem Turbocode, einem systematischen Code, einem systematischen Polarcode und einem Code einer Paritätsprüfung mit niedriger Dichte bzw. LDPC-Code (200).

4. Vorrichtung (500) nach einem der Ansprüche 1 bis 3, wobei das vordefinierte Modulationsschema eines umfasst von einem Quadratur-Amplitudenmodulationsschema bzw. QAM-Schema, einem Phasenumtastungsmodulationsschema bzw. PSK-Modulationsschema und einem Quadratur-PSK-Modulationsschema bzw. QPSK-Modulationsschema.

5. Vorrichtung (500) nach einem der Ansprüche 1 bis 4, wobei der Prozessor (502) außerdem konfiguriert ist zum Ermitteln der Übertragungsqualitäten der Datenübertragungsschichten im Vorhinein basierend auf Uplink-Referenzsignalen im Fall von Zeitduplexkommunikationen bzw. TDD-Kommunikationen oder Downlink-Referenzsignalen im Fall von Frequenzduplexkommunikationen bzw. FDD-Kommunikationen.

6. Vorrichtung (500) nach einem der Ansprüche 1 bis 8, wobei die Datenübertragungsschichten räumliche Schichten mit mehreren Eingängen und mehreren Ausgängen bzw. räumliche MIMO-Schichten umfassen.

7. Verfahren (700) für drahtlose Kommunikationen, umfassend:

Empfangen (S702) eines Codeworts (510), das über Datenübertragungsschichten übertragen werden soll, wobei jede der Datenübertragungsschichten eine Übertragungsqualität aufweist, wobei das Codewort (510) unter Verwendung eines linearen Codes erhalten wird, wobei das Codewort (510) eine Codewortlänge $E$ aufweist und Codewortbits umfasst, wobei die Codewortbits mindestens ein Informationsbit und mindestens ein Paritätsbit umfassen;
Verschachteln (S704) der Codewortbits, indem eine Matrix (800) mit $n$ Zeilen und $k$ Spalten verwendet wird, wobei $n$ und $k$ basierend auf einem vordefinierten Modulationsschema und der Codewortlänge $E$ ausgewählt werden, wobei jede der Spalten einer der Datenübertragungsschichten entspricht und wobei das Verschachteln (S704) umfasst:

- Anordnen, in mindestens einer ersten Spaltengruppe (802), der Spalten, die den Datenübertragungsschichten entsprechen, deren Übertragungsqualitäten gleich einem Schwellenwert sind oder über diesem liegen;
- Anordnen, in mindestens einer zweiten Spaltengruppe (804), der Spalten, die den Datenübertragungsschichten entsprechen, deren Übertragungsqualitäten unter dem Schwellenwert liegen;
- Schreiben der Codewortbits zeilenweise in die mindestens eine erste Spaltengruppe (802) und die mindestens eine zweite Spaltengruppe (804) beginnend mit dem Schreiben des mindestens einen Informationsbits zeilenweise in die mindestens eine erste Spaltengruppe (802);
- Zusammenführen der mindestens einen ersten Spaltengruppe (802) und der mindestens einen zweiten Spaltengruppe (804), um die Matrix (800) wiederherzustellen; und
- Lesen der Codewortbits spaltenweise aus der Matrix (800);

Erhalten (S706), indem das vordefinierte Modulationsschema verwendet wird, eines Modulationssymbols (812) für die Codewortbits, die aus jeder Spalte der Matrix (800) ausgelesen wurden;
Zuordnen (S708) der Modulationssymbole (810) zu den Datenübertragungsschichten; und
Senden (S710) der zugeordneten Modulationssymbole (512) zu einer drahtlosen Zielkommunikationsvorrichtung,
wobei das vordefinierte Modulationsschema eine Modulationsordnung $Q_m$ aufweist und wobei $n$ gleich der Modulationsordnung $Q_m$ ist, während k erhalten wird, indem eine Abrundungs- oder Aufrundungsfunktion auf ein Verhältnis der Codewortlänge $E$ zur Modulationsordnung $Q_m$ angewandt wird,
wobei das vordefinierte Modulationsschema eine Zuordnung eines $Q_m$-Tupel der Codewortbits für jede Spalte der Matrix (800) zu dem Modulationssymbol (810) definiert, und wobei das Verfahren (700) außerdem umfasst:

Ermitteln von Bitkapazitäten der Codewortbits in jedem $Q_m$-Tupel basierend auf den Übertragungsqualitäten der Datenübertragungsschichten; und
Ermitteln, basierend auf den ermittelten Bitkapazitäten: (i) einer Anzahl $G$ der mindestens einen ersten Spaltengruppe (802) und der mindestens einen zweiten Spaltengruppe (804), in welche die Spalten der Matrix (800) angeordnet werden sollen,
und (ii) einer Entsprechung von jeder der Datenübertragungsschichten mit der mindestens einen ersten Spaltengruppe (802) oder der mindestens einen zweiten Spaltengruppe (804);
wobei das Verfahren (700) vor dem Senden (S710) der zugeordneten Modulationssymbole (512) außerdem umfasst:
Erzeugen einer Steuernachricht, die mindestens eine umfasst von:

der Modulationsordnung $Q_m$;
der Codewortlänge $E$;

der Anzahl *G* der mindestens einen ersten Spaltengruppe (802) und der mindestens einen zweiten Spaltengruppe (804), die verwendet wird, wenn die Codewortbits verschachtelt werden, und der Entsprechung von jeder der Datenübertragungsschichten mit der mindestens einen ersten Spaltengruppe (802) oder der mindestens einen zweiten Spaltengruppe (804); und Senden der Steuernachricht zu der drahtlosen Zielkommunikationsvorrichtung.

8. Verfahren (700) nach Anspruch 7, das vor dem Verschachteln (S704) außerdem ein Ermitteln der Modulationsordnung $Q_m$ des vordefinierten Modulationsschemas basierend auf den Übertragungsqualitäten der Datenübertragungsschichten umfasst.

9. Verfahren (700) nach Anspruch 7 oder 8, wobei das Codewort (510) unter Verwendung des linearen Codes erhalten wird, der ausgewählt wird aus einem von einem Turbocode, einem systematischen Code, einem systematischen Polarcode und einem Code einer Paritätsprüfung mit niedriger Dichte bzw. LDPC-Code (200).

10. Verfahren (700) nach einem der Ansprüche 7 bis 9, wobei das vordefinierte Modulationsschema eines umfasst von einem Quadratur-Amplitudenmodulationsschema bzw. QAM-Schema, einem Phasenumtastungsmodulationsschema bzw. PSK-Modulationsschema und einem Quadratur-PSK-Modulationsschema bzw. QPSK-Modulationsschema.

11. Verfahren (700) nach einem der Ansprüche 7 bis 10, das außerdem ein Ermitteln der Übertragungsqualitäten der Datenübertragungsschichten im Vorhinein basierend auf Uplink-Referenzsignalen im Fall von Zeitduplexkommunikationen bzw. TDD-Kommunikationen oder Downlink-Referenzsignalen im Fall von Frequenzduplexkommunikationen bzw. FDD-Kommunikationen umfasst.

12. Verfahren (700) nach einem der Ansprüche 7 bis 11, wobei die Datenübertragungsschichten räumliche Schichten mit mehreren Eingängen und mehreren Ausgängen bzw. räumliche MIMO-Schichten umfassen.

13. Computerprogrammprodukt, das ein computerlesbares Speichermedium umfasst, wobei das computerlesbare Speichermedium einen Computercode umfasst, der, wenn er von mindestens einem Prozessor ausgeführt wird, den Prozessor veranlasst, das Verfahren (700) nach einem der Ansprüche 7 bis 12 durchzuführen.


**Revendications**

1. Appareil (500) pour un système de communication sans fil, comprenant :

   un processeur (502) ;
   une mémoire (504) couplée au processeur (502) et configurée pour stocker des instructions (508) exécutables par processeur, le processeur (502) étant configuré, lorsqu'il exécute les instructions (508) exécutables par processeur, pour :

   recevoir un mot de code (510) à envoyer sur des couches de transmission de données, chacune des couches de transmission de données présentant une qualité de transmission, le mot de code (510) étant obtenu au moyen d'un code linéaire, le mot de code (510) présentant une longueur *E* de mot de code et comprenant des bits de mot de code, les bits de mot de code comprenant au moins un bit d'information et au moins un bit de parité ;
   entrelacer les bits de mot de code par utilisation d'une matrice (800) à n lignes et *k* colonnes, *n* et *k* étant sélectionnés sur la base d'un schéma de modulation prédéfini et de la longueur *E* de mot de code, chacune des colonnes correspondant à l'une des couches de transmission de données, et ledit entrelacement comprenant :

      - l'agencement, en au moins un premier groupe de colonnes (802), des colonnes correspondant aux couches de transmission de données dont les qualités de transmission sont supérieures ou égales à un seuil ;
      - l'agencement, en au moins un deuxième groupe de colonnes (804), des colonnes correspondant aux couches de transmission de données dont les qualités de transmission sont inférieures au seuil ;
      - l'écriture des bits de mot de code ligne par ligne dans l'au moins un premier groupe de colonnes (802) et l'au moins un deuxième groupe de colonnes (804), en commençant par l'écriture de l'au moins un bit d'information ligne par ligne dans l'au moins un premier groupe de colonnes (802) ;
- la fusion de l'au moins un premier groupe de colonnes (802) et de l'au moins un deuxième groupe de colonnes (804) pour restaurer la matrice (800) ; et
- la lecture des bits de mot de code colonne par colonne dans la matrice (800) ;

obtenir, par utilisation du schéma de modulation prédéfini, un symbole de modulation (810) pour les bits de mot de code lus dans chaque colonne de la matrice ; et
mapper les symboles de modulation (810) sur les couches de transmission de données ; et
un émetteur-récepteur (506) configuré pour envoyer les symboles de modulation mappés (512) à un appareil de communication sans fil cible,
le schéma de modulation prédéfini présentant un ordre de modulation $Q_m$, et $n$ étant égal à l'ordre de modulation $Q_m$, tandis que $k$ est obtenu par application d'une fonction plancher ou plafond à un rapport de la longueur $E$ de mot de code sur l'ordre de modulation $Q_m$ ;
le schéma de modulation prédéfini définissant un mappage d'un $Q_m$-uplet des bits de mot de code pour chaque colonne de la matrice (800) sur le symbole de modulation (810), et le processeur (502) étant configuré en outre pour :

déterminer des capacités en bits des bits de mot de code dans chaque $Q_m$-uplet sur la base des qualités de transmission des couches de transmission de données ; et
sur la base des capacités en bits déterminées, déterminer : (i) un nombre $G$ de l'au moins un premier groupe de colonnes (802) et de l'au moins un deuxième groupe de colonnes (804) en lesquels les colonnes de la matrice (800) doivent être agencées, et (ii) une correspondance de chacune des couches de transmission de données avec l'au moins un premier groupe de colonnes (802) ou l'au moins un deuxième groupe de colonnes (804) ; et
le processeur (502) étant configuré en outre, avant d'amener l'émetteur-récepteur à envoyer les symboles de modulation mappés (512), pour :
générer un message de commande comprenant au moins un des éléments suivants :

l'ordre de modulation $Q_m$ ;
la longueur $E$ de mot de code ;
le nombre $G$ de l'au moins un premier groupe de colonnes (802) et de l'au moins un deuxième groupe de colonnes (804) utilisé lors de l'entrelacement des bits de mot de code ; et
la correspondance de chacune des couches de transmission de données avec l'au moins un premier groupe de colonnes (802) ou l'au moins un deuxième groupe de colonnes (804) ; et
amener l'émetteur-récepteur (506) à envoyer le message de commande à l'appareil de communication sans fil cible.

2. Appareil (500) selon la revendication 1, le processeur (502) étant configuré en outre, avant ledit entrelacement, pour déterminer l'ordre de modulation $Q_m$ du schéma de modulation prédéfini sur la base des qualités de transmission des couches de transmission de données.

3. Appareil (500) selon la revendication 1 ou 2, le mot de code (510) étant obtenu au moyen du code linéaire sélectionné parmi un turbocode, un code systématique, un code polaire systématique, et un code à contrôle de parité de faible densité, noté LDPC (200).

4. Appareil (500) selon l'une quelconque des revendications 1 à 3, le schéma de modulation prédéfini comprenant un schéma parmi un schéma de modulation d'amplitude en quadrature, notée QAM, un schéma de modulation par déplacement de phase, notée PSK, et un schéma de modulation PSK en quadrature, notée QPSK.

5. Appareil (500) selon l'une quelconque des revendications 1 à 4, le processeur (502) étant configuré en outre pour déterminer les qualités de transmission des couches de transmission de données à l'avance sur la base de signaux de référence sur la liaison montante dans le cas de communications par duplexage à répartition dans le temps, noté TDD, ou de signaux de référence sur la liaison descendante dans le cas de communications par duplexage à répartition en fréquence, noté FDD.

6. Appareil (500) selon l'une quelconque des revendications 1 à 8, les couches de transmission de données comprenant des couches spatiales multi-entrées multi-sorties, notées MIMO.

7. Procédé (700) pour des communications sans fil, comprenant :

la réception (S702) d'un mot de code (510) à envoyer sur des couches de transmission de données, chacune des couches de transmission de données présentant une qualité de transmission, le mot de code (510) étant obtenu au moyen d'un code linéaire, le mot de code (510) présentant une longueur $E$ de mot de code et comprenant des bits de mot de code, les bits de mot de code comprenant au moins un bit d'information et au moins un bit de parité ;

l'entrelacement (S704) des bits de mot de code par utilisation d'une matrice (800) à $n$ lignes et $k$ colonnes, $n$ et $k$ étant sélectionnés sur la base d'un schéma de modulation prédéfini et de la longueur $E$ de mot de code, chacune des colonnes correspondant à l'une des couches de transmission de données, et ledit entrelacement (S704) comprenant :

- l'agencement, en au moins un premier groupe de colonnes (802), des colonnes correspondant aux couches de transmission de données dont les qualités de transmission sont supérieures ou égales à un seuil ;
- l'agencement, en au moins un deuxième groupe de colonnes (804), des colonnes correspondant aux couches de transmission de données dont les qualités de transmission sont inférieures au seuil ;
- l'écriture des bits de mot de code ligne par ligne dans l'au moins un premier groupe de colonnes (802) et l'au moins un deuxième groupe de colonnes (804), en commençant par l'écriture de l'au moins un bit d'information ligne par ligne dans l'au moins un premier groupe de colonnes (802) ;
- la fusion de l'au moins un premier groupe de colonnes (802) et de l'au moins un deuxième groupe de colonnes (804) pour restaurer la matrice (800) ; et
- la lecture des bits de mot de code colonne par colonne dans la matrice (800) ;

l'obtention (S706), par utilisation du schéma de modulation prédéfini, d'un symbole de modulation (812) pour les bits de mot de code lus dans chaque colonne de la matrice (800) ;

le mappage (S708) des symboles de modulation (810) sur les couches de transmission de données ; et

l'envoi (S710) des symboles de modulation mappés (512) à un appareil de communication sans fil cible, le schéma de modulation prédéfini présentant un ordre de modulation $Q_m$, et $n$ étant égal à l'ordre de modulation $Q_m$, tandis que $k$ est obtenu par application d'une fonction plancher ou plafond à un rapport de la longueur $E$ de mot de code sur l'ordre de modulation $Q_m$ ;

le schéma de modulation prédéfini définissant un mappage d'un $Q_m$-uplet des bits de mot de code pour chaque colonne de la matrice (800) sur le symbole de modulation (810), et le procédé (700) comprenant en outre :

la détermination de capacités en bits des bits de mot de code dans chaque $Q_m$-uplet sur la base des qualités de transmission des couches de transmission de données ; et

sur la base des capacités en bits déterminées, la détermination de : (i) un nombre $G$ de l'au moins un premier groupe de colonnes (802) et de l'au moins un deuxième groupe de colonnes (804) en lesquels les colonnes de la matrice (800) doivent être agencées,

et (ii) une correspondance de chacune des couches de transmission de données avec l'au moins un premier groupe de colonnes (802) ou l'au moins un deuxième groupe de colonnes (804) ;

le procédé (700) comprenant en outre, avant ledit envoi (S710) des symboles de modulation mappés (512) :

la génération d'un message de commande comprenant au moins un des éléments suivants :

l'ordre de modulation $Q_m$ ;

la longueur $E$ de mot de code ;

le nombre $G$ de l'au moins un premier groupe de colonnes (802) et de l'au moins un deuxième groupe de colonnes (804) utilisé lors de l'entrelacement des bits de mot de code ; et

la correspondance de chacune des couches de transmission de données avec l'au moins un premier groupe de colonnes (802) ou l'au moins un deuxième groupe de colonnes (804) ; et

l'envoi du message de commande à l'appareil de communication sans fil cible.

8. Procédé (700) selon la revendication 7, comprenant en outre, avant ledit entrelacement (S704), la détermination de l'ordre de modulation $Q_m$ du schéma de modulation prédéfini sur la base des qualités de transmission des couches de transmission de données.

9. Procédé (700) selon la revendication 7 ou 8, le mot de code (510) étant obtenu au moyen du code linéaire sélectionné parmi un turbocode, un code systématique, un code polaire systématique, et un code à contrôle de parité de faible densité, noté LDPC (200).

**10.** Procédé (700) selon l'une quelconque des revendications 7 à 9, le schéma de modulation prédéfini comprenant un schéma parmi un schéma de modulation d'amplitude en quadrature, notée QAM, un schéma de modulation par déplacement de phase, notée PSK, et un schéma de modulation PSK en quadrature, notée QPSK.

**11.** Procédé (700) selon l'une quelconque des revendications 7 à 10, comprenant en outre la détermination des qualités de transmission des couches de transmission de données à l'avance sur la base de signaux de référence sur la liaison montante dans le cas de communications par duplexage à répartition dans le temps, noté TDD, ou de signaux de référence sur la liaison descendante dans le cas de communications par duplexage à répartition en fréquence, noté FDD.

**12.** Procédé (700) selon l'une quelconque des revendications 7 à 11, les couches de transmission de données comprenant des couches spatiales multi-entrées multi-sorties, notées MIMO.

**13.** Produit-programme d'ordinateur comprenant un support de stockage lisible par ordinateur, le support de stockage lisible par ordinateur comprenant un code d'ordinateur qui, lorsqu'il est exécuté par au moins un processeur, amène l'au moins un processeur à réaliser le procédé (700) selon l'une quelconque des revendications 7 à 12.

**FIG. 1**

200

206 — 2Z bits

P

K-2Z bits

202 — Information bits

204 — (E-K+2Z) bits

Parity bits

e = 1 2 ... K-2Z K-2Z+1 ... E

*Punctured information bits*

**FIG. 2**

FIG. 3

FIG. 4

**FIG. 5**

**FIG. 6**

**FIG. 7**

S702 — Receiving a codeword to be transmitted over data transmission layers each having a transmission quality

S704 — Interleaving codeword bits by: arranging columns of a matrix into a first column group and a second column group based on the transmission qualities of the layers; writing the codeword bits into the groups, starting with writing information bits of the codeword bits into the first column group; merging the groups to restore the matrix; and reading the codeword bits column-wise from the matrix

S706 — Obtaining a modulation symbol for the codeword bits read from each column of the matrix

S708 — Mapping the modulation symbols to the data transmission layers

S710 — Sending the mapped modulation symbols to a target wireless communication apparatus

700

FIG. 8

**FIG. 9**

EP 4 218 141 B1

Transmission #1, interleaver 106     1000

| | | | | | | | | | | | | |
|---|---|---|---|---|---|---|---|---|---|---|---|---|
| 1st bit → | 0.78 | 0.68 | 0.78 | 0.68 | | | | | | | 0.78 | 0.68 |
| 2nd bit → | 0.78 | 0.68 | 0.78 | 0.68 | | | | | | | 0.78 | 0.68 |
| 3rd bit → | 0.56 | 0.4 | 0.56 | 0.4 | | | | | | | 0.56 | 0.4 |
| 4th bit → | 0.56 | 0.4 | 0.56 | 0.4 | | | | | | | 0.56 | 0.4 |

Transmission #1, interleaver 604     1002

| | | | | | | | | | | | | |
|---|---|---|---|---|---|---|---|---|---|---|---|---|
| 1st bit → | 0.78 | 0.68 | 0.78 | 0.68 | | | | | | | 0.78 | 0.68 |
| 2nd bit → | 0.78 | 0.68 | 0.78 | 0.68 | | | | | | | 0.78 | 0.68 |
| 3rd bit → | 0.56 | 0.4 | 0.56 | 0.4 | | | | | | | 0.56 | 0.4 |
| 4th bit → | 0.56 | 0.4 | 0.56 | 0.4 | | | | | | | 0.56 | 0.4 |

1st layer, SNR=8 dB     2nd layer, SNR=6 dB

**FIG. 10**

EP 4 218 141 B1

Transmission #2, interleaver 106    1100

| 1st bit → | 0.93 | 0.47 | 0.93 | 0.47 | | | | | | | 0.93 | 0.47 |
| 2nd bit → | 0.93 | 0.47 | 0.93 | 0.47 | | | | | | | 0.93 | 0.47 |
| 3rd bit → | 0.86 | 0.16 | 0.86 | 0.16 | | | | | | | 0.86 | 0.16 |
| 4th bit → | 0.86 | 0.16 | 0.86 | 0.16 | | | | | | | 0.86 | 0.16 |

Transmission #2, interleaver 604    1102

| 1st bit → | 0.93 | 0.47 | 0.93 | 0.47 | | | | | | | 0.93 | 0.47 |
| 2nd bit → | 0.93 | 0.47 | 0.93 | 0.47 | | | | | | | 0.93 | 0.47 |
| 3rd bit → | 0.86 | 0.16 | 0.86 | 0.16 | | | | | | | 0.86 | 0.16 |
| 4th bit → | 0.86 | 0.16 | 0.86 | 0.16 | | | | | | | 0.86 | 0.16 |

1st layer, SNR=12 dB    2nd layer, SNR=2 dB

**FIG. 11**

EP 4 218 141 B1

FIG. 12

**FIG. 13A**

**FIG. 13B**

EP 4 218 141 B1

**FIG. 14A**

**FIG. 14B**

**FIG. 15A**

EP 4 218 141 B1

**FIG. 15B**

**REFERENCES CITED IN THE DESCRIPTION**

**Patent documents cited in the description**

- US 2009063929 A1
- US 2018212628 A1
- US 2020119845 A1